# EUROPEAN PATENT APPLICATION

(11) **EP 4 842 183 A1**
(43) Date of publication of application: **18.11.2026**
(21) Application number: 26173053.5
(22) Date of filing: 17.04.2026
(51) Int. Cl.: H10N 50/85, H10N 50/01, H10N 50/10

(54) **PLATINUM-ZIRCONIUM ALLOY-BASED MAGNETIC SWITCHING DEVICE AND METHOD OF MANUFACTURING THE SAME**

(30) Priority: 16.05.2025 KR 20250063994; 29.10.2025 KR 20250159200
(71) Applicant: Korea University Research and Business Foundation, Seoul 02841 (KR)
(72) Inventor: KIM, Young Keun, 06009 Seoul (KR); LEE, Jin Seo, 02853 Seoul (KR); LEE, Jeong Kyu, 04145 Seoul (KR)
(74) Representative: Prüfer & Partner mbB Patentanwälte · Rechtsanwälte

(57) **Abstract**

The present invention relates to a platinum-zirconium alloy-based magnetic switching device and a method for manufacturing the same, and more particularly, to a method for manufacturing a magnetization switching device in which an alloy layer including platinum (Pt) and zirconium (Zr) is formed by a magnetron co-sputtering process to implement a spin torque layer that maintains perpendicular magnetic anisotropy, and a free layer formed of cobalt (Co) or cobalt-iron-boron (CoFeB) is stacked on the spin torque layer, while a thickness of the free layer and interface roughness are precisely controlled, thereby simultaneously achieving a low magnetization switching current density and a high spin transfer efficiency.

## Description

### CROSS-REFERENCE TO RELATED APPLICATION

This application claims priority from and the benefit of Korean Patent Application No. 10-2025-0063994 filed on May 16, 2025, and 10-2025-0159200 filed on October 29, 2025, in the Korean Intellectual Property Office, the disclosure of which is incorporated herein by reference.

### BACKGROUND OF THE DISCLOSURE

### Field of the Disclosure

Example embodiments relate to a spin torque-based switching device, and more particularly, to a structure in which perpendicular magnetic anisotropy (PMA) is maintained depending on a microstructure after thin-film deposition and spin-orbit torque (SOT) switching is achievable, the structure being associated with a composition range and a structural configuration of a platinum (Pt)-zirconium (Zr) alloy thin film in which a low magnetization switching current density and a high spin-orbit torque efficiency are observed.

### Description of the Related Art

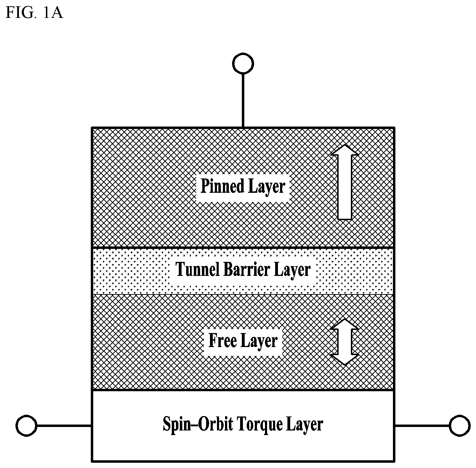

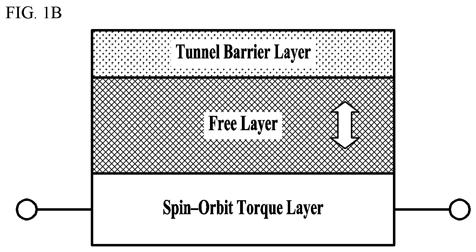

A magnetic tunnel junction (MTJ), which is a core device of spin-orbit torque (SOT) switching-based magnetic random access memory (MRAM), is composed, as illustrated in FIGS. 1A and 1B, of a non-magnetic spin torque generating layer (hereinafter, a spin torque layer), a first magnetic layer (a magnetization free layer, hereinafter, a free layer), a tunnel barrier layer, and a second magnetic layer (a magnetization fixed layer, hereinafter, a fixed layer).

In particular, the magnetic tunnel junction reads information by utilizing a tunneling magnetoresistance (TMR) effect in which an electrical resistance value of a tunneling current passing through the insulating layer varies depending on a relative magnetization direction between the free layer and the fixed layer.

FIG. 1A illustrates a basic structure of a spin-orbit torque (SOT)-based magnetic tunnel junction, and FIG. 1B illustrates a structure for measuring spin-orbit torque efficiency.

The structure of FIG. 1A corresponds to a structure of the present invention and is capable of replacing a conventional heterojunction structure shown in FIG. 1B.

In order to achieve a high tunneling magnetoresistance ratio, high write stability, a low write current, and high integration density, the magnetic tunnel junction is required to essentially exhibit perpendicular magnetic anisotropy (PMA).

The perpendicular magnetic anisotropy refers to a characteristic in which a magnetization direction of a magnetic layer is perpendicular to a plane of the magnetic layer.

Recently, a spin-orbit torque (SOT) phenomenon, in which switching of a free layer is induced by a spin Hall effect or a Rashba effect generated when a current flows in an in-plane direction of a spin torque layer adjacent to the free layer, has been identified, and has attracted attention as a technology capable of performing information writing at a higher speed and with lower current consumption than a conventional spin-transfer torque (STT) writing scheme.

Accordingly, a core technical challenge in this technical field lies in implementing a device structure in which a material system applied to the spin torque layer is precisely designed to secure a large spin Hall angle (SHA), which represents spin-orbit torque efficiency, while maintaining a low resistivity.

### [Prior Art Documents]

### [Patent Documents]

Korean Registered Patent No. 10-2787478, titled "Spin-Orbit Torque (SOT)-Type Magnetoresistive Memory and Method of Manufacturing the Same."
Korean Registered Patent No. 10-2705726, titled "Magnetic Multilayer Film, Magnetic Memory Device, and Magnetic Memory."
Korean Registered Patent No. 10-2576209, titled "Semiconductor Device Having a Spin-Orbit Torque Line."

### SUMMARY

An object of the present invention is to implement a spin-orbit torque device material system that simultaneously satisfies a low resistivity and a large spin Hall angle (SHA) by adopting a platinum-zirconium (Pt-Zr) alloy as a spin torque layer.

Another object of the present invention is to provide an optimized design of a stack structure, thickness, and composition that reduces a magnetization switching critical current density (J_{c}) while stably maintaining perpendicular magnetic anisotropy (PMA) of a free layer.

Another object of the present invention is to establish interface engineering that simultaneously suppresses spin backflow and reduces spin memory loss (SML) at an interface between a Pt-Zr alloy layer and a free layer, thereby maximizing spin transfer efficiency (Tᵢₙₜ).

Another object of the present invention is to propose a field-free deterministic switching structure operable without an auxiliary external magnetic field, thereby reducing system complexity and driving cost.

Another object of the present invention is to secure long-term stability of switching characteristics and readout metrics, including resistance-area product (RA) and tunneling magnetoresistance (TMR), over a wide temperature range from -55 °C to +150 °C and under repeated thermal cycling conditions.

Another object of the present invention is to establish a manufacturing method for precisely controlling a composition, an areal density, and uniformity of a platinum-zirconium alloy through a co-sputtering-based process and quantitative verification using Rutherford backscattering spectrometry (RBS).

Another object of the present invention is to minimize interface-roughness-induced loss and enhance spin transparency by controlling surface roughness such that both a root-mean-square roughness (R_{q}) and an arithmetic average roughness (Rₐ) are maintained at a level of 0.1 nm to 0.2 nm.

Another object of the present invention is to provide circuit-device co-design guidelines that minimize Joule heating and IR drop by coupling a four-point-probe-based resistivity ρₓₓ(T) temperature-dependence model with current distribution analysis.

A magnetic switching device according to an embodiment may include a spin torque layer made of an alloy of platinum (Pt) and zirconium (Zr), the spin torque layer maintaining perpendicular magnetic anisotropy, and a free layer formed on the spin torque layer, the free layer having a magnetization direction that is switchable.

A method of manufacturing a platinum-zirconium alloy-based magnetic switching device according to an embodiment may include forming a spin torque layer that maintains perpendicular magnetic anisotropy by depositing an alloy on a substrate using a target containing platinum (Pt) and zirconium (Zr), and forming a free layer having a switchable magnetization direction on the formed spin torque layer.

According to one embodiment, a damping-like spin-orbit torque efficiency (ξ_{DL}) in a Pt-Zr/Co heterojunction can be improved up to approximately 0.175 based on a Pt_{83.4}Zr_{16.6}/Co reference.

According to one embodiment, in the same structure, a magnetization switching critical current density (J_{c}) can be reduced to approximately 12.14 MA/cm², which is substantially lower than that of a conventional Pt/Co structure.

According to one embodiment, within a zirconium (Zr) composition range of 0 to 18.8 at%, perpendicular magnetic anisotropy of a free layer is stably maintained, thereby enabling high-bandwidth, low-current switching even with a thin free layer.

According to one embodiment, an optimal free-layer thickness can be derived by quantifying a reduction in interfacial magnetic anisotropy (Kₛ) and a critical thickness (t*) through linear scaling of a product of an effective magnetic anisotropy constant and a free-layer thickness (K_{eff} × t) versus t_{FM}, and through Kₛ-composition analysis.

According to one embodiment, as a zirconium (Zr) content increases, a spin transparency (Tᵢₙₜ) increases from approximately 0.27 to approximately 0.40, thereby significantly enhancing a net forward spin injection rate across an interface.

According to one embodiment, field-free switching can be stably achieved without an external auxiliary magnetic field by employing an asymmetric stack combined with a lower auxiliary magnetic layer.

According to one embodiment, switching signals based on R_{AHE} and critical current characteristics can be stably maintained even under repeated thermal cycling conditions between -55 °C and +150 °C.

According to one embodiment, a surface roughness measured by atomic force microscopy (AFM), with R_{q} and Rₐ ≈ 0.1-0.2 nm, is maintained substantially constant over an entire composition range, thereby minimizing spin loss and variability induced by surface roughness.

According to one embodiment, platinum-zirconium composition and areal density can be reliably verified through matching between Rutherford backscattering spectrometry (RBS) measurements and simulations, thereby securing process reproducibility and within-wafer uniformity.

According to one embodiment, low-power operation and array scalability can be simultaneously achieved by quantitatively designing current distribution and Joule heating using four-point-probe-based resistivity ρₓₓ(T) data in conjunction with a parallel resistor network model.

### BRIEF DESCRIPTION OF THE FIGURES

Embodiments will be described in more detail with regard to the figures, wherein like reference numerals refer to like parts throughout the various figures unless otherwise specified, and wherein:
FIG. 1A is a diagram illustrating a basic structure of a spin-orbit torque (SOT)-based magnetic tunnel junction.
FIG. 1B is a diagram illustrating a structure for measuring spin-orbit torque efficiency.
FIG. 2 is a diagram illustrating a structure of a platinum-zirconium alloy-based magnetic switching device according to one embodiment.
FIGS. 3A to 3C are diagrams illustrating results of analyzing a microstructure of a platinum-zirconium alloy using X-ray diffraction analysis.
FIG. 4 is a diagram illustrating results of analyzing a microstructure of a platinum-zirconium alloy using transmission electron microscopy.
FIGS. 5A to 5D are diagrams illustrating results of electromagnetic property analysis of a platinum-zirconium alloy.
FIGS. 6A to 6D are diagrams illustrating results of measuring spin-orbit torque efficiency in a Ta/Pt-Zr/Co/Ta structure using a harmonic Hall voltage measurement method.
FIGS. 7A to 7C are diagrams illustrating results of analyzing a spin current generation mechanism of a platinum-zirconium alloy.
FIGS. 8A to 8C are diagrams illustrating results of analyzing magnetization switching and temperature stability in a heterojunction structure using a platinum-zirconium alloy.
FIGS. 9A to 9C are diagrams illustrating results of magnetization switching in a field-free switching structure using a platinum-zirconium alloy.
FIG. 10 is a diagram illustrating results of quantitatively identifying a zirconium composition through Rutherford backscattering spectrometry (RBS) in a Si/SiO₂ substrate/Pt-Zr structure.
FIGS. 11A to 11D are diagrams illustrating a magnetic hysteresis loop, an effective saturation magnetization analysis, and behavior of effective saturation magnetization according to a zirconium composition in a structure using a platinum-zirconium alloy.
FIGS. 12A and 12B are diagrams illustrating results of analyzing magnetic anisotropy at an interface between a platinum-zirconium alloy and a free layer based on perpendicular magnetic anisotropy energy.
FIG. 13 is a diagram illustrating surface roughness of a Ta/Pt-Zr structure.
FIG. 14 is a diagram illustrating results of calculating spin transfer efficiency at an interface between a platinum-zirconium alloy and a free layer in a Ta/Pt-Zr/Co/Ta structure.
FIG. 15 is a diagram illustrating results of analyzing magnetic anisotropy at an interface between a platinum-zirconium alloy and a free layer based on perpendicular magnetic anisotropy energy, and resistivity of the alloy measured at different temperatures using a four-point probe method.
FIG. 16 is a diagram illustrating results of measuring a magnetization switching current density according to a change in an external magnetic field with respect to a zirconium composition in a Ta/Pt-Zr/Co/Ta structure.
FIGS. 17A to 17E are diagrams illustrating orientation of spin-polarized currents in a perpendicular direction in a field-free switching structure using a platinum-zirconium alloy.

### DETAILED DESCRIPTION OF THE DISCLOSURE

The embodiments according to the inventive concept disclosed in this specification are provided for the purpose of describing the inventive concept, and specific structural or functional descriptions thereof are merely illustrative. Accordingly, the embodiments according to the inventive concept may be implemented in various forms and are not limited to the embodiments described herein.

Since the embodiments according to the inventive concept may be subject to various modifications and may take various forms, the embodiments are illustrated in the drawings and described in detail in this specification. However, this is not intended to limit the embodiments according to the inventive concept to specific disclosed forms, and the inventive concept includes all modifications, equivalents, or alternatives falling within the spirit and technical scope of the present invention.

Terms such as "first" and "second" may be used to describe various components, but such components should not be limited by these terms. These terms are used only for the purpose of distinguishing one component from another, and, for example, without departing from the scope of the inventive concept, a first component may be referred to as a second component, and similarly, a second component may be referred to as a first component.

When a component is described as being "connected to" or "coupled to" another component, it should be understood that the component may be directly connected or coupled to the other component, or that intervening components may be present. In contrast, when a component is described as being "directly connected to" or "directly coupled to" another component, it should be understood that no intervening components are present. Expressions describing relationships between components, such as "between" and "directly between" or "adjacent to," should be interpreted in a similar manner.

The terminology used herein is for the purpose of describing particular embodiments only and is not intended to limit the present invention. Singular forms are intended to include plural forms unless the context clearly indicates otherwise. As used herein, the terms "comprising" or "having" specify the presence of stated features, numbers, steps, operations, components, parts, or combinations thereof, but do not preclude the presence or addition of one or more other features, numbers, steps, operations, components, parts, or combinations thereof.

Unless otherwise defined, all terms used herein, including technical and scientific terms, have the same meaning as commonly understood by one of ordinary skill in the art to which the present invention pertains. Terms defined in commonly used dictionaries should be interpreted as having meanings consistent with their meanings in the context of the relevant art and should not be interpreted in an idealized or overly formal sense unless expressly defined herein.

Hereinafter, embodiments will be described in detail with reference to the accompanying drawings. However, the scope of the patent application is not limited or restricted by such embodiments. The same reference numerals presented in the respective drawings denote the same elements.

Hereinafter, embodiments will be described in detail with reference to the accompanying drawings. However, the scope of the patent application is not limited or restricted by such embodiments. The same reference numerals presented in the respective drawings denote the same elements.

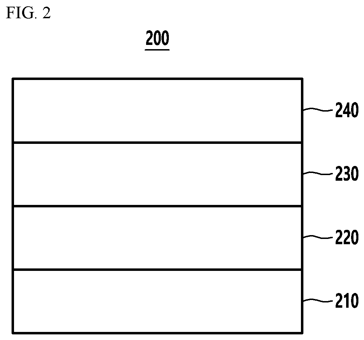

FIG. 2 illustrates a stacked structure of a platinum-zirconium alloy-based magnetic switching device 200 according to one embodiment.

The platinum-zirconium alloy-based magnetic switching device 200 according to one embodiment includes a seed layer 210 formed on a substrate, and a spin torque layer 220 stacked on the seed layer 210, the spin torque layer 220 being made of an alloy of platinum (Pt) and zirconium (Zr) and maintaining perpendicular magnetic anisotropy.

Further, the platinum-zirconium alloy-based magnetic switching device 200 according to one embodiment includes a free layer 230 formed on the spin torque layer 220, the free layer 230 having a magnetization direction that is switchable, and may further include a capping layer 240 formed to protect the free layer 230.

In particular, the spin torque layer 220 according to one embodiment may be formed of an alloy in which platinum (Pt) and zirconium (Zr) have a composition ranging from 0.1 at% to 18.8 at%.

More specifically, when a zirconium (Zr) composition ranges from 5.4 at% to 18.8 at%, a stable solid-solution state may be maintained and perpendicular magnetic anisotropy may be exhibited. When the zirconium (Zr) composition exceeds this range and increases excessively, a preferred (111) orientation of a face-centered cubic (fcc) structure of platinum is lost, a microstructure becomes amorphous, and perpendicular magnetic anisotropy is not maintained.

The spin torque layer 220 may be formed using a magnetron co-sputtering method in order to secure film uniformity and achieve a uniform distribution of zirconium atoms within the alloy. In this process, a platinum target and a zirconium target are simultaneously subjected to direct-current (DC) magnetron sputtering to form the alloy, and sputtering power applied to each target is precisely controlled to achieve a desired composition ratio. Deposition is performed in an argon (Ar) atmosphere, and an initial vacuum is maintained at an ultra-high-vacuum level of 5×10⁻⁹ Torr or less. Under these conditions, the deposited alloy preserves face-centered cubic (fcc) crystallinity in terms of microstructure, while exhibiting a tendency for grain size to decrease as the zirconium composition increases.

The formed alloy may exhibit a resistivity in a range from 40 µΩ·cm to 150 µΩ·cm in terms of electrical properties. This behavior is consistent with a tendency in which resistivity increases as a zirconium composition increases in accordance with the Nordheim rule. In addition, since an electronic mean free path exists at a level comparable to a grain size, grain refinement induced by zirconium addition increases grain-boundary scattering of electrons, thereby acting as a factor that further increases resistivity.

Accordingly, the spin torque layer 220 can simultaneously implement perpendicular magnetic anisotropy and a low magnetization switching current density through control of a composition ratio of a platinum-zirconium alloy, formation process conditions, and microstructure, which provides a key basis for enhancing spin-orbit torque efficiency and enabling low-power operation.

Meanwhile, the free layer 230 may be formed of cobalt (Co) or cobalt-iron-boron (CoFeB), and a thickness thereof may be precisely controlled to range from 0.8 nm to 1.2 nm. When the thickness of the free layer 230 is less than 0.8 nm, formation of a continuous thin film becomes difficult and magnetic continuity is not secured. Conversely, when the thickness exceeds 1.2 nm, perpendicular magnetic anisotropy (PMA) is weakened, thereby making it difficult to achieve high integration density. Accordingly, the above thickness range is an optimized condition for maintaining perpendicular magnetic anisotropy while securing a low magnetization switching current density.

The free layer 230 may be formed to maintain a (111) crystallographic orientation of a face-centered cubic (fcc) structure in order to ensure stability of magnetization switching. This induces strong orbital hybridization (Pt 5d-Co 3d or Pt 5d-Fe 3d bonding) at an interface with the spin torque layer 220, thereby increasing interfacial magnetic anisotropy and consequently providing stable perpendicular magnetic anisotropy even during long-term operation.

In practice, a cobalt (Co) or cobalt-iron-boron (CoFeB) free layer formed on a platinum-zirconium alloy exhibits excellent perpendicular magnetic anisotropy characteristics when a zirconium composition ratio is in a range from 5.4 at% to 18.8 at%, which has been confirmed through magnetic hysteresis loops measured using a vibrating sample magnetometer (VSM).

Furthermore, since an interface between the spin torque layer 220 and the free layer 230 directly affects spin transparency (Tᵢₙₜ), the interface may be formed as an ultra-flat interface having a surface roughness of 0.2 nm or less.

As an interface becomes rough, spin scattering increases, thereby reducing spin-orbit torque (SOT) efficiency and destabilizing magnetization switching characteristics. Accordingly, direct-current (DC) magnetron co-sputtering conditions in an argon (Ar) atmosphere are optimized, and an initial vacuum during deposition is maintained at 5×10⁻⁹ Torr or less to suppress impurity adsorption, thereby enabling formation of an ultra-flat interface.

Further, results of transmission electron microscopy (TEM) and energy-dispersive X-ray spectroscopy (EDS) analyses confirm that, under such conditions, an interface between a platinum-zirconium alloy and cobalt exhibits a uniform atomic distribution.

The seed layer 210 is generally formed of a material such as tantalum (Ta), and plays a key role in controlling a growth direction and crystallinity of the platinum-zirconium alloy. The tantalum (Ta) seed layer is formed in an amorphous state to induce an upper platinum-zirconium alloy to maintain a face-centered cubic (fcc) (111) orientation, thereby stabilizing perpendicular magnetic anisotropy of the free layer 230.

The capping layer 240 functions to protect the free layer 230 from an external environment. Since a cobalt (Co) or cobalt-iron-boron (CoFeB) free layer is sensitive to oxidation and may experience rapid degradation of magnetic properties upon exposure, the capping layer protects the free layer from deterioration caused by oxygen or moisture.

For example, a tantalum (Ta) capping layer formed on an upper side naturally forms a stable tantalum oxide (TaOₓ) layer by bonding with oxygen, thereby securing long-term stability of the free layer. In addition, it has been experimentally confirmed that, even under repeated thermal cycling conditions between -55 °C and 150 °C, the capping layer serves as a protective barrier to minimize variation in magnetization switching current density.

Further, the platinum-zirconium alloy-based magnetic switching device 200 may include forming the spin torque layer 220 by depositing an alloy on a substrate using a target containing platinum (Pt) and zirconium (Zr) during a manufacturing process, and subsequently forming the free layer 230 on the spin torque layer 220.

Moreover, in one embodiment, the platinum-zirconium alloy-based magnetic switching device 200 may be implemented by sequentially stacking, on a Si/SiO₂ substrate, a tantalum (Ta) seed layer 210 having a thickness of 2 nm, a platinum-zirconium alloy spin torque layer 220 having a thickness of 5 nm, a cobalt (Co) free layer 230 having a thickness of 1.2 nm, and a tantalum (Ta) capping layer 240 having a thickness of 2 nm. Here, Si denotes a substrate, and the SiO₂ layer is a naturally formed amorphous oxide layer on the substrate.

During stacking of metal layers, DC magnetron sputtering is employed, an initial vacuum is maintained at 5×10⁻⁹ Torr or less, and deposition is performed in an argon (Ar) atmosphere.

In addition, during operation of the platinum-zirconium alloy-based magnetic switching device 200, when an in-plane current is applied to the spin torque layer 220, a spin current is generated by a spin Hall effect and the like, and the generated spin current is delivered to the free layer 230 to induce magnetization switching. Accordingly, the platinum-zirconium alloy-based magnetic switching device 200 can implement stable magnetization switching with a low driving current while maintaining perpendicular magnetic anisotropy through optimization of a zirconium (Zr) composition, control of a thickness of the free layer 230, and control of surface roughness.

Further, it can be confirmed that the platinum-zirconium alloy-based magnetic switching device 200 exhibits perpendicular magnetic anisotropy when a zirconium (Zr) composition is within a range from 0 at% to 18.8 at%.

In addition, the platinum-zirconium alloy-based magnetic switching device 200 may exhibit a tendency in which resistivity of the platinum-zirconium alloy follows the Nordheim rule. Furthermore, as necessary, the platinum-zirconium alloy-based magnetic switching device 200 may be patterned and provided with electrodes, and spin-orbit torque efficiency may be evaluated through harmonic Hall resistance measurements and the like.

By way of example, a method of manufacturing a platinum-zirconium alloy-based magnetic switching device begins with depositing an alloy on a substrate using a target containing platinum (Pt) and zirconium (Zr).

In this step, the manufacturing method forms a spin torque layer such that the alloy maintains perpendicular magnetic anisotropy, and the formed spin torque layer serves as a base layer that enables a core operation of the magnetic switching device.

The method of manufacturing the platinum-zirconium alloy-based magnetic switching device according to one embodiment further includes forming, on the formed spin torque layer, a free layer having a magnetization direction that can be stably reversed in response to an external stimulus. The free layer is an important factor that determines switching characteristics of the device, and the magnetization direction thereof is controlled by a flow of spin current in a magnetic tunnel junction structure.

The alloy may be formed as an alloy in which platinum (Pt) and zirconium (Zr) have a precisely controlled composition ratio ranging from 5.4 at% to 18.8 at%. By controlling the ratio of platinum and zirconium within this composition range, the manufacturing method allows the alloy to simultaneously provide optimal spin-orbit torque characteristics and perpendicular magnetic anisotropy. When the composition ratio deviates from the specified range, perpendicular magnetic anisotropy may be weakened or switching efficiency may be degraded, and thus control of the alloy composition is a key factor for ensuring device performance.

The alloy is formed using a magnetron co-sputtering method. In this process, the manufacturing method deposits the alloy by simultaneously sputtering a platinum target and a zirconium target, thereby securing a uniform composition and a desired thickness. The magnetron co-sputtering method has an advantage of stabilizing atomic arrangement and microstructure within the alloy, thereby improving spin torque characteristics.

The free layer is formed of cobalt (Co) or cobalt-iron-boron (CoFeB), and a thickness of the free layer is precisely set to range from 0.8 nm to 1.2 nm. By limiting the thickness of the free layer to this range, the manufacturing method enables the device to simultaneously secure stable magnetization switching characteristics and a low critical current density. Selection of cobalt (Co) or cobalt-iron-boron (CoFeB) as a material of the free layer is made to provide a high spin polarization ratio and a low magnetization switching energy, and, as a result, excellent switching characteristics are implemented through coupling with the platinum-zirconium alloy-based spin torque layer.

Accordingly, the method of manufacturing the platinum-zirconium alloy-based magnetic switching device precisely controls an alloy composition and a formation method thereof, as well as a material and thickness of the free layer, thereby simultaneously securing perpendicular magnetic anisotropy and spin-orbit torque characteristics and enabling implementation of a high-efficiency, low-power, and high-stability magnetic switching device.

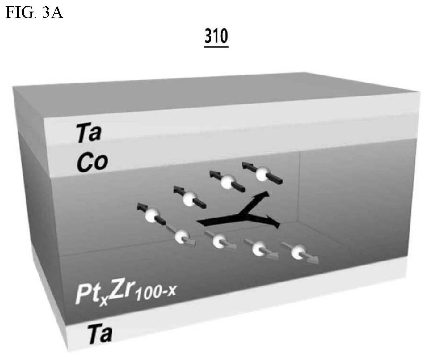

FIGS. 3A to 3C are diagrams illustrating results of analyzing a microstructure of a platinum-zirconium alloy.

FIG. 3A (310) schematically illustrates a stacking concept in which a seed layer (Ta) is formed on a substrate, a platinum-zirconium alloy (Pt₁₀₀₋ₓZrₓ) is stacked thereon, and a free layer (Co) and a capping layer (Ta) are sequentially formed.

FIG. 3A (310) further visually illustrates a process in which, when an in-plane current flows through the platinum-zirconium alloy serving as a spin torque layer, a spin current generated by a spin Hall effect is injected into the free layer (Co) and applies a damping-like torque, thereby inducing magnetization switching.

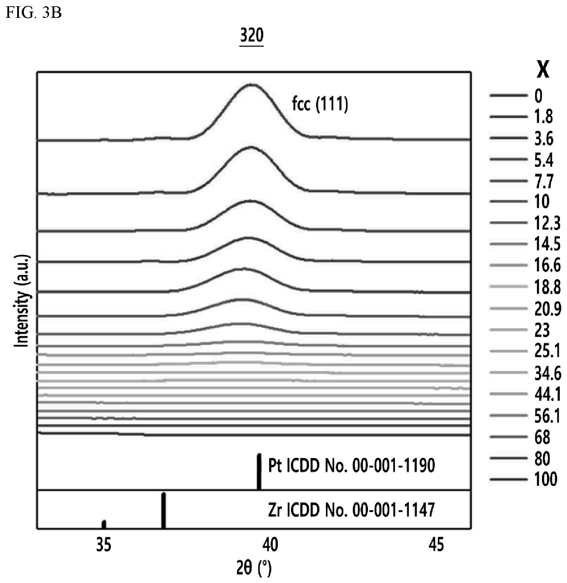

Accordingly, FIG. 3A (310) provides a conceptual background for understanding that an interface between a platinum-rich alloy spin torque layer and a cobalt (Co) free layer, which constitutes a core of the present invention, determines a correlation between device operation and microstructure, and that crystallographic analysis results shown in FIGS. 3B to 3C form a basis for device characteristics.

FIG. 3B (320) illustrates X-ray diffraction (θ-2θ) patterns of the platinum-zirconium alloy arranged according to a change in zirconium composition (x = 0 → 100 at%).

First, in a platinum (Pt)-rich region where x = 0-20.9 at%, a face-centered cubic (fcc) (111) diffraction peak is clearly observed. As a zirconium (Zr) content increases, a peak position slightly shifts toward a lower-angle side, and a peak width (full width at half maximum, FWHM) gradually increases. This indicates expansion of a lattice constant due to zirconium substitution (decrease in a Bragg angle) and grain refinement and/or increased lattice disorder (peak broadening).

Next, up to approximately x ≈ 23 at%, a (111) preferred orientation is maintained. However, when x exceeds 25.1 at%, the (111) preferred-orientation signal is rapidly weakened or disappears, and a peak becomes broad and low relative to a background, indicating degradation of crystallinity (a quasi-amorphous/amorphous tendency).

In addition, reference diffraction lines of platinum-zirconium are exemplarily shown at a lower portion of FIG. 3B (320), enabling a direct correspondence that the observed peaks originate from the fcc (111) plane of platinum (Pt).

As a result, FIG. 3B (320) demonstrates that, in a platinum-rich solid-solution range in which a small amount of zirconium (Zr) is introduced, fcc (111) crystallographic order is maintained, whereas, when the zirconium (Zr) content exceeds a certain critical composition (approximately 23-25 at%), long-range order collapses and a phase change/structural transition occurs in which preferred orientation and crystallinity are lost.

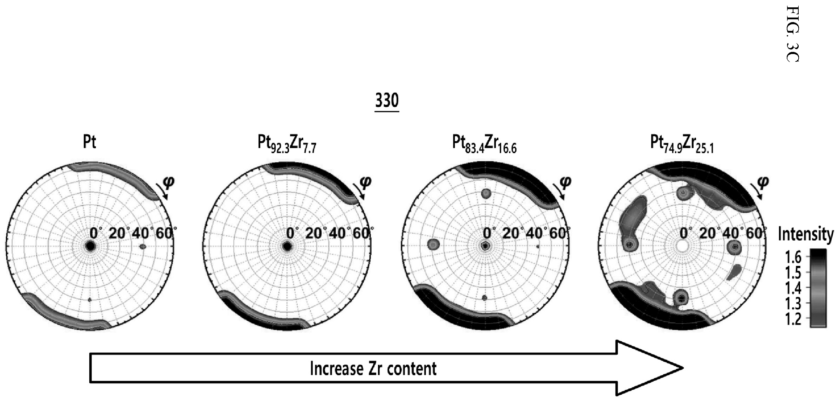

FIG. 3C (330) illustrates a comparison of {111} pole figures corresponding to a stepwise increase in zirconium (Zr) composition for four representative compositions, namely Pt, Pt_{92.3}Zr_{7.7}, Pt_{83.4}Zr_{16.6}, Pt_{74.9}Zr_{25.1}.

First, in Pt (pure Pt) and Pt_{92.3}Zr_{7.7}, a strong peak appears at the origin. This indicates that a preferred orientation along the (111) direction is strongly formed and that a film normal direction is consistently aligned with a {111} family of poles.

Next, in Pt_{83.4}Zr_{16.6}, a strong peak is also observed at the origin. Although an intensity of the peak decreases and peripheral peaks appear, the central peak remains distinct, which is consistent with the result of FIG. 3B (320) showing a clear (111) diffraction peak.

In contrast, in Pt_{74.9}Zr_{25.1}, the peak at the origin disappears. This indicates that collapse of the (111) preferred orientation has progressed, which is consistent with weakening or disappearance of the (111) diffraction peak identified in FIG. 3B (320).

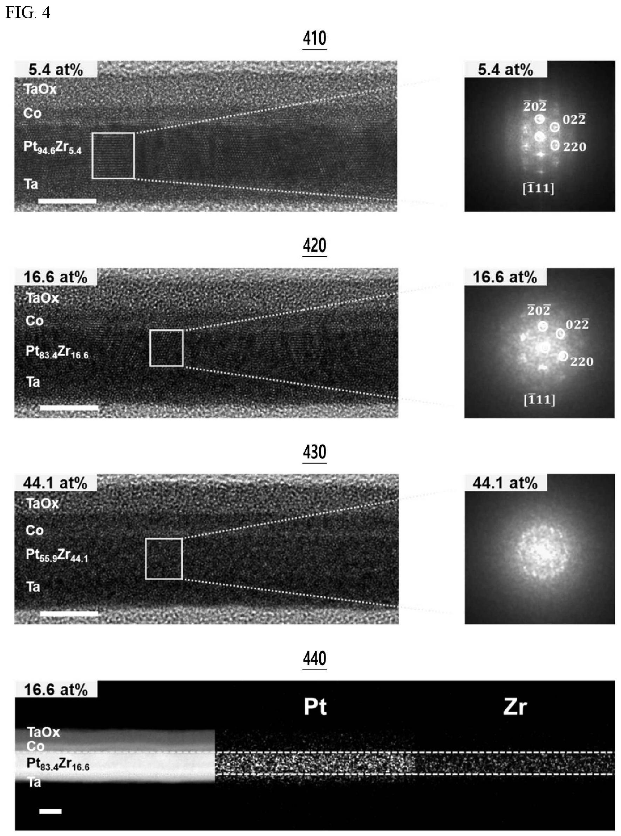

FIG. 4 is a diagram illustrating results of electromagnetic property analysis of a platinum-zirconium alloy.

FIG. 4 collectively illustrates, in a single figure, microstructural characteristics, diffraction features, and elemental distributions that govern electromagnetic properties of the platinum-zirconium alloy. Specifically, FIG. 4 includes (i) cross-sectional high-resolution transmission electron microscopy (HRTEM) analysis according to composition, (ii) selected-area fast Fourier transform (FFT) diffraction patterns acquired from the same regions, and (iii) scanning transmission electron microscopy energy-dispersive spectroscopy (STEM-EDS) elemental mapping for representative compositions.

### Transmission Electron Microscopy and FFT Analysis of a Pt_{94.6}Zr_{5.4} Specimen (Low Zr Composition)

An upper portion 410 of FIG. 4 illustrates a cross-sectional stack of Ta/Pt_{94.6}Zr_{5.4}/Co/TaOx.

In transmission electron microscopy images, a platinum-zirconium alloy exhibits a regular lattice that is continuously observed over an entire thickness, and an interface between the platinum-zirconium alloy and cobalt is flat and shows a clear boundary.

Fast Fourier transform (FFT) diffraction patterns obtained from a magnified region exhibit distinct spot-like diffraction features corresponding to {111}, {220}, and {202} families associated with a face-centered cubic (fcc) platinum (Pt) framework.

These observations indicate that, at this composition, a platinum-rich solid solution is formed and that long-range crystallographic order and a (111) preferred orientation are maintained.

### Transmission Electron Microscopy and FFT Analysis of a Pt_{83.4}Zr_{16.6} Specimen (Optimal Composition Range)

A middle portion 420 of FIG. 4 illustrates a cross-sectional view of a specimen having a Pt_{83.4}Zr_{16.6} composition.

In high-resolution transmission electron microscopy (HRTEM) analysis, a crystalline structure remains clearly observable, while partial increase in structural disorder is observed.

Corresponding fast Fourier transform (FFT) diffraction patterns maintain {111} and {220} diffraction spots, indicating that face-centered cubic (fcc) (111) crystallinity is preserved.

### Transmission Electron Microscopy and FFT Analysis of a Pt_{55.9}Zr_{44.1} Specimen (High Zirconium Composition)

A lower portion 430 of FIG. 4 illustrates a cross-sectional view of a specimen having a Pt_{55.9}Zr_{44.1} composition.

At this composition, transmission electron microscopy (TEM) analysis shows that lattice periodicity is significantly weakened and amorphous characteristics are dominant.

Corresponding fast Fourier transform (FFT) diffraction patterns show disappearance of discrete spot features, which clearly indicates collapse of long-range order and randomization of crystallographic orientation.

Accordingly, when a zirconium (Zr) content exceeds a critical level, the platinum-zirconium alloy transitions from a platinum-rich solid solution to an amorphous phase.

### STEM-EDS Elemental Mapping of a Pt_{83.4}Zr_{16.6} Specimen (Representative Composition)

A lower panel 440 of FIG. 4 illustrates results of scanning transmission electron microscopy energy-dispersive spectroscopy (STEM-EDS) elemental mapping for a representative Pt_{83.4}Zr_{16.6} specimen.

Signals of platinum (Pt) and zirconium (Zr) are simultaneously detected (co-localized) throughout an entire region of the alloy, and no in-plane compositional variation or macroscopic segregation is observed.

In addition, an abrupt change in elemental signals is identified along an interface between the platinum-zirconium alloy and cobalt, indicating that interfacial interdiffusion is suppressed.

These results indicate that a solid solution is formed at the representative composition, such that pathways for charge and spin currents are homogeneous. (An inset image on a left side of the drawing exemplifies a stacking overview and a scale bar of the same region.)

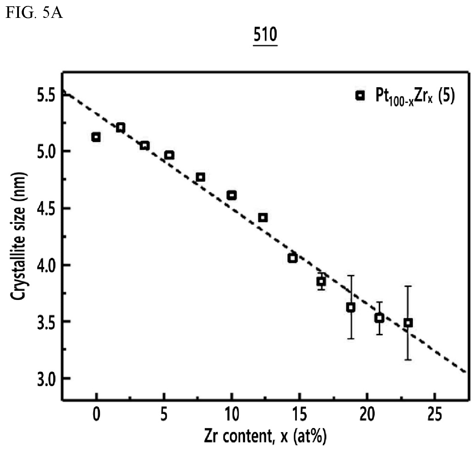

FIGS. 5A to 5D are diagrams illustrating results of electromagnetic property analysis of a platinum-zirconium alloy.

FIG. 5A (510) illustrates a change in grain size of a platinum-zirconium alloy (thickness: 5 nm) as a function of a zirconium (Zr) composition (x, at%).

The grain size was calculated by interpreting a full width at half maximum (FWHM) of a (111) diffraction peak obtained from θ-2θ X-ray diffraction (XRD) analysis using the Scherrer equation.

When the zirconium (Zr) composition is 0 at%, an average grain size of approximately 5.1 nm is observed. As the zirconium (Zr) composition increases, the grain size gradually decreases, reaching approximately 3.5 nm at a composition of 23 at%. These results indicate that substitution of zirconium (Zr) atoms into a platinum (Pt) lattice induces lattice distortion and promotes microstructural disordering. Error bars in the graph represent a standard deviation (1σ) from repeated measurements, thereby ensuring reliability of the measured values. Accordingly, FIG. 5A (510) clearly shows a process in which crystallinity of the alloy gradually degrades as the zirconium (Zr) content increases.

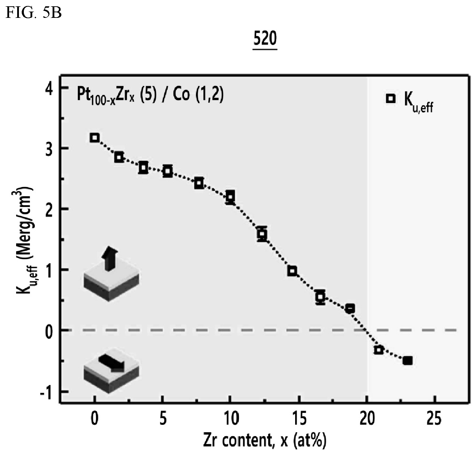

FIG. 5B (520) illustrates an effective magnetic anisotropy constant K_{u,eff} of a Pt₁₀₀₋ₓZrₓ (5)/Co (1.2) stacked structure (units: nm) as a function of the zirconium (Zr) composition.

The effective magnetic anisotropy constant K_{u,eff} was calculated from an anisotropy energy value obtained by comparing magnetic hysteresis loops measured in perpendicular and in-plane directions, while considering a saturation magnetization Mₛ and a magnetic layer thickness t_{FM}.

As a result, when the zirconium (Zr) composition is within a range from 0 at% to approximately 18.8 at%, K_{u,eff} maintains a positive (+) value, confirming stable perpendicular magnetic anisotropy (PMA). However, when the zirconium (Zr) composition exceeds 20 at%, K_{u,eff} gradually decreases and eventually transitions to a negative (-) value, indicating loss of perpendicular magnetic anisotropy and a transition of magnetization to an in-plane direction. Such a change is attributed to weakening of 5d-3d orbital hybridization at a platinum-zirconium interface and collapse of a face-centered cubic (fcc) (111) preferred orientation due to zirconium (Zr) addition. Accordingly, FIG. 5B (520) identifies a compositional limit for stability of magnetic anisotropy as a function of the zirconium (Zr) content.

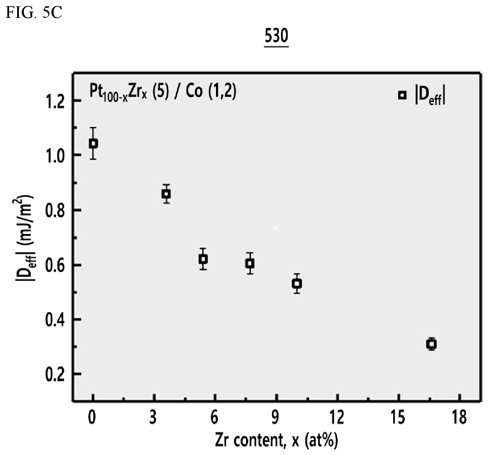

FIG. 5C (530) illustrates an effective Dzyaloshinskii-Moriya interaction (DMI) constant D_{eff} in a Pt₁₀₀₋ₓZrₓ (5)/Co (1.2) stacked structure (units: nm).

The effective DMI constant D_{eff} was derived by analyzing asymmetric bubble domain expansion and domain-wall velocity curves under an in-plane external magnetic field Hₓ.

As the zirconium (Zr) composition increases, D_{eff} exhibits a monotonic decreasing trend, indicating that a strength of spin-orbit coupling at a Pt-Zr/Co interface is weakened compared to that at a Pt/Co interface. In addition, interfacial mixing and microstructural inhomogeneity induced by zirconium (Zr) addition further contribute to weakening of the Dzyaloshinskii-Moriya interaction. Accordingly, FIG. 5C (530) concretely shows that compositional variation of the platinum-zirconium alloy directly affects interfacial interactions.

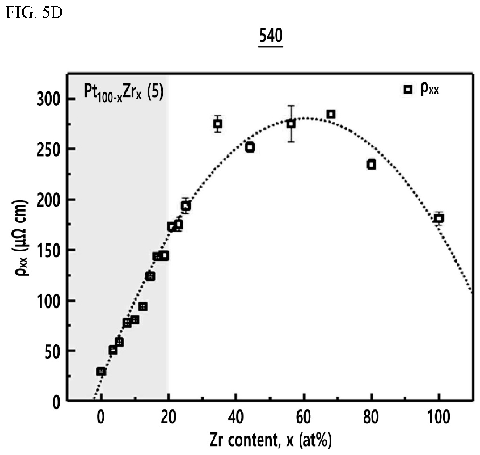

FIG. 5D (540) illustrates an electrical resistivity ρₓₓ of a platinum-zirconium alloy as a function of the zirconium (Zr) composition.

The resistivity exhibits a parabolic increasing trend in accordance with the Nordheim rule. In a low zirconium (Zr) composition range, the resistivity is close to that of a single platinum (Pt) layer (approximately 29 µΩ·cm). As the zirconium (Zr) composition increases, the resistivity rapidly increases, exceeding approximately 150 µΩ·cm around 20 at%. This behavior is interpreted as a result of reduced grain size and enhanced grain-boundary scattering directly affecting charge transport properties. In addition, in a high zirconium (Zr) composition region, amorphous structural characteristics appear and electron mobility is significantly reduced, thereby further increasing the resistivity. Accordingly, FIG. 5D (540) quantitatively presents a specific influence of compositional variation on electrical conduction characteristics. [Equation 1] $D = \frac{Kλ}{β cos θ}$

[Equation 1] is the Scherrer equation, which is used to estimate a crystallite size from X-ray diffraction (XRD) analysis.

In [Equation 1], D denotes an average crystallite size (in nm or Å), and K denotes a Scherrer constant (shape factor), which typically has a value in a range from about 0.89 to 1.0.

λ denotes a wavelength of an X-ray source used for the measurement (for example, approximately 0.154 nm for a Cu Kα radiation), and β denotes a full width at half maximum (FWHM) of a diffraction peak, converted into radians.

θ denotes a Bragg angle, that is, a central angle of the diffraction peak.

Accordingly, [Equation 1] indicates that, as a diffraction peak width β measured in XRD becomes broader, the calculated crystallite size D becomes smaller, which is a characteristic commonly observed in nanocrystalline materials or thin films.

When results of FIGS. 5A to 5D are considered collectively, it is confirmed that, as the zirconium (Zr) composition increases,
(i) the crystallite size decreases,
(ii) K_{u,eff} gradually decreases and perpendicular magnetic anisotropy (PMA) is lost beyond a certain composition range,
(iii) D_{eff} monotonically decreases, thereby weakening an ability to control an interfacial spin structure, and
(iv) an electrical resistivity ρₓₓ rapidly increases.

These results clearly demonstrate that compositional control of a platinum-zirconium alloy is a key parameter that governs performance of a platinum-zirconium-alloy-based magnetic device. In addition, the results suggest that optimizing the zirconium (Zr) composition within a range of approximately 5 at% to 18 at% is effective for simultaneously achieving a low driving current and high reliability.

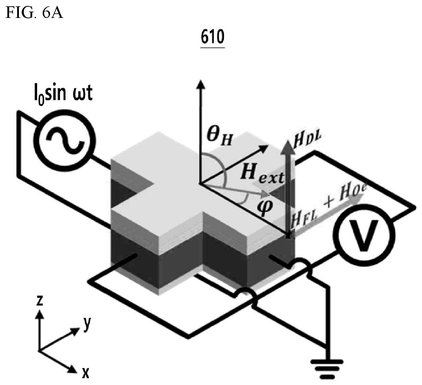

FIGS. 6A to 6D are diagrams illustrating results of measuring spin-orbit torque (SOT) efficiency in a Ta/Pt-Zr/Co/Ta structure using a harmonic Hall voltage measurement method.

In particular, FIG. 6A (610) illustrates a schematic configuration of a Ta/Pt-Zr/Co/Ta stacked structure to which the harmonic Hall voltage measurement method is applied (units: nm).

In FIG. 6A (610), an alternating current I(t) = I₀ sin(ωt) is applied along an x-axis direction, and an external magnetic field Hₑₓₜ is applied in a direction defined by a polar angle θ_{H} and an azimuthal angle Φ within a plane of the sample.

A magnetization m of a free layer (Co) is expressed by a polar angle θ and an azimuthal angle Φ, and a spin current generated in a spin torque layer (Pt-Zr) applies, with respect to m, a damping-like effective field H_{DL} and a field-like effective field H_{FL}, respectively.

In FIG. 6A (610), a Hall voltage V_{xy} is decomposed into a first-harmonic component ${V}_{xy}^{1 ω}$ and a second-harmonic component ${V}_{xy}^{2 ω}$, which are simultaneously measured using a lock-in amplifier. Corresponding Hall resistances are respectively defined as ${R}_{xy}^{1 ω} = {V}_{xy}^{1 ω} / {I}_{0} , {R}_{xy}^{2 ω} = {V}_{xy}^{2 ω} / {I}_{0}$*.*

In FIG. 6A (610), an effective magnetic field H_{eff} acting on the magnetization includes effective anisotropy and demagnetization field components acting along a measurement direction, and thus may be approximated as H_{eff} ≃ Hₑₓₜ ± H_{K}, where a sign is selected according to a direction of magnetization switching. [Equation 2] ${R}_{xy}^{2 ω} = \left[{R}_{AHE}\frac{{H}_{DL}}{{H}_{eff}}+{R}_{∇ T}\right] cos φ + 2 {R}_{PHE} \left(2{cos}^{3}φ-cosφ\right) \frac{{H}_{FL} + {H}_{Oe}}{{H}_{ext}}$ ${R}_{xy}^{2 ω}$ denotes a second-harmonic Hall resistance, and R_{AHE} denotes an anomalous Hall effect resistance.

In addition, H_{DL} represents an effective field arising from a damping-like torque, and H_{eff} denotes an effective magnetic field.

Further, ***R_{∇T}*** represents a contribution term associated with a thermally induced voltage (thermal contribution, voltage term), and φ denotes an azimuthal angle of an applied external magnetic field.

R_{PHE} denotes a planar Hall effect resistance, and H_{FL} represents an effective field arising from a field-like torque.

H_{oc} denotes an Oersted field (a magnetic field generated by an applied current), and Hₑₓₜ denotes an applied external magnetic field.

[Equation 2] is a relationship in which a measured second-harmonic Hall signal is decomposed into cosφ and (2cos³φ - cosφ) components, such that H_{DL} and H_{FL} are respectively extracted from the corresponding terms.

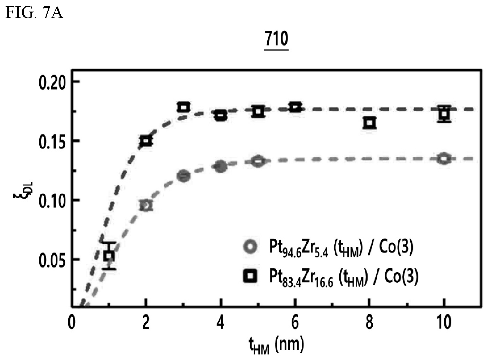

FIGS. 7A to 7C are diagrams illustrating results of analyzing a mechanism by which a spin current is generated in a platinum-zirconium (Pt-Zr) alloy, wherein each graph shows, in detail, correlations between spin-orbit torque (SOT) and related physical quantities as a function of zirconium (Zr) addition.

FIG. 7A (710) is a graph illustrating variations in a damping-like torque efficiency ξ_{DL} as a function of a thickness t_{HM} of a heavy-metal (HM) layer serving as a spin torque layer in Pt_{94.6}Zr_{5.4}/Co and Pt_{83.4}Zr_{16.6}/Co structures. The value of ξ_{DL} gradually increases with increasing t_{HM} and then exhibits a saturation behavior when t_{HM} exceeds approximately 4 nm for Pt_{94.6}Zr_{5.4}/Co and approximately 3 nm for Pt_{83.4}Zr_{16.6}/Co. This behavior indicates that, as a zirconium (Zr) content increases, a carrier lifetime becomes shorter, such that saturation occurs even at a relatively smaller thickness. Such thickness dependence implies that a spin Hall effect (SHE) is a primary contributor to generation of spin-orbit torque (SOT).

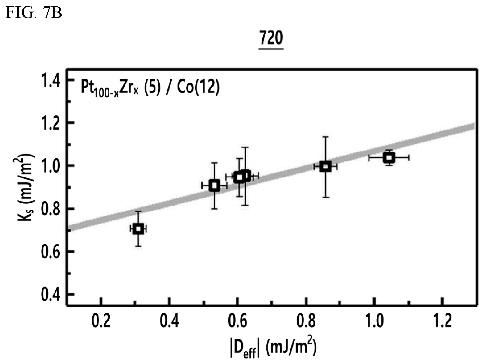

FIG. 7B (720) shows a correlation between a surface magnetic anisotropy Kₛ and an effective Dzyaloshinskii-Moriya interaction (DMI) energy D_{eff} measured in a Pt₁₀₀₋ₓZrₓ (5)/Co (1.2) structure (units: nm). The graph indicates that Kₛ is linearly proportional to D_{eff}, suggesting that the correlation originates from interfacial spin-orbit coupling of a Rashba type. In other words, as the interfacial spin-orbit coupling decreases, both Kₛ and D_{eff} decrease together. Nevertheless, the observation that ξ_{DL} increases with increasing zirconium (Zr) content, despite a reduced interfacial contribution, indicates that the spin Hall effect is dominant.

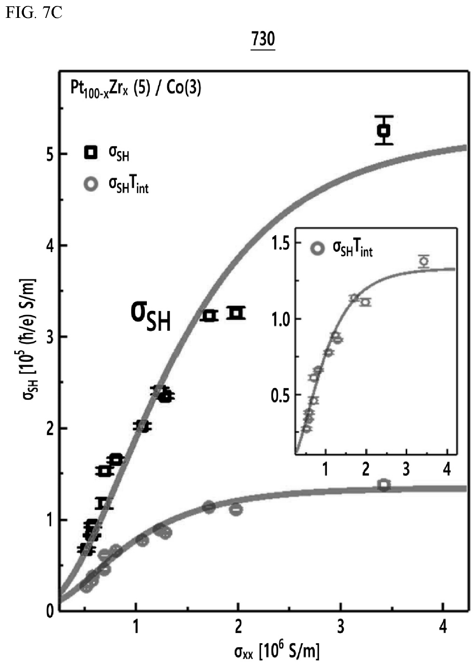

FIG. 7C (730) illustrates variations in a spin Hall conductivity σ_{SH} and σ_{SH} Tᵢₙₜ as a function of an electrical conductivity σₓₓ in a Pt₁₀₀₋ₓZrₓ (5)/Co (3) structure (units: nm). According to the measurements, for platinum (Pt), σ_{SH} exhibits a value of approximately 5.25 × 10³ ( 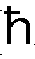 /e)(Ω·m)⁻¹. As the zirconium (Zr) content increases, σ_{SH} gradually decreases, reaching approximately 0.83 × 10³ ( 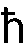 /e)(Ω·m)⁻¹ at x = 23 at%. Such behavior differs from a regime dominated by extrinsic contributions, such as skew scattering or side-jump mechanisms, thereby indicating that an intrinsic spin Hall effect is the primary origin.

Accordingly, from the results of FIGS. 7A to 7C, it can be understood that addition of zirconium (Zr) to a platinum-zirconium alloy enhances spin-orbit torque (SOT) efficiency via an intrinsic spin Hall effect. In particular, the highest ξ_{DL} is observed at a Pt_{83.4}Zr_{16.6} composition, which is thus identified as an optimal composition.

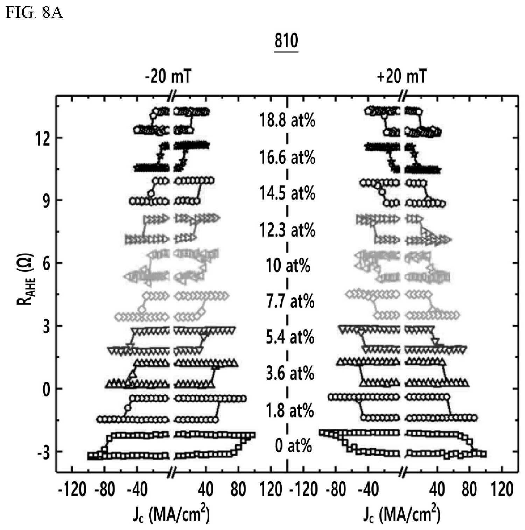

FIGS. 8A to 8C are diagrams illustrating results of analyzing magnetization switching and temperature stability in a heterojunction structure employing a platinum-zirconium alloy.

FIG. 8A (810) illustrates variations in an anomalous Hall resistance R_{AHE} measured while sweeping a current density J_{c} under an in-plane external magnetic field (Hₓ = ±20 mT) in a Hall-bar specimen fabricated with a stacked structure of Ta (2)/Pt-Zr (5)/Co (1.2)/Ta (2) (units: nm).

FIG. 8A (810) includes a series of specimens in which a zirconium composition x is varied to 0, 1.8, 3.6, 5.4, 7.7, 10, 12.3, 14.5, 16.6, and 18.8 at%. In FIG. 8A (810), R_{AHE} forms two stable levels corresponding to upward and downward out-of-plane magnetization states, and exhibits a step-like behavior whenever J_{c} exceeds a critical value.

FIG. 8A (810) provides a forward critical current density J_{c}⁺ and a reverse critical current density J_{c}⁻ under conditions of Hₓ = -20 mT and Hₓ = +20 mT, respectively.

As x increases, |J_{c}^{±}| clearly shows a monotonic decreasing trend. In particular, FIG. 8A (810) shows that a minimum critical current density is obtained around x = 16.6 at%, where |J_{c}| is reduced to approximately 1.2 × 107 A/cm². The reduction in the critical current density observed in FIG. 8A (810) is attributed to (i) enhancement of a damping-like torque due to an intrinsic spin Hall conductivity of the platinum-zirconium alloy, and (ii) a decrease in perpendicular magnetic anisotropy resulting from an increased zirconium (Zr) composition.

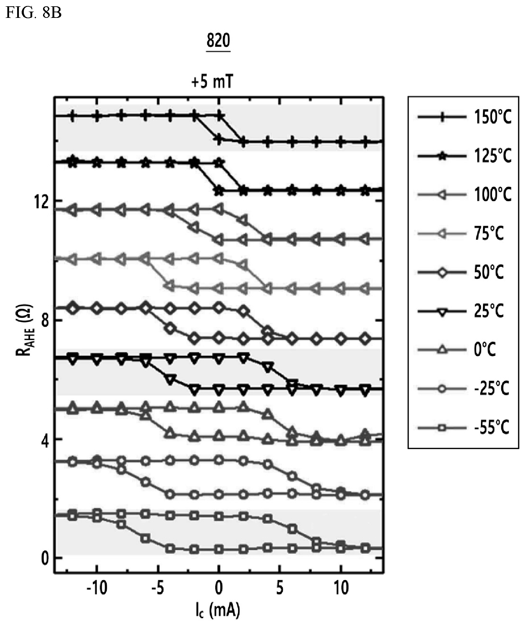

FIG. 8B (820) illustrates magnetization behavior as a function of an applied current I_{c}, represented by R_{AHE}, while varying temperature stepwise from -55 °C to +150 °C under a fixed in-plane assist magnetic field Hₓ = +5 mT, using a representative specimen with x = 16.6 at%.

FIG. 8B (820) shows that clear bidirectional magnetization switching loops are reproducibly obtained at all temperature points, indicating that spin-orbit-torque-induced magnetization switching is deterministically realized in both low-temperature (-55 °C) and high-temperature (+150 °C) environments. As temperature increases, the critical current I_{c} gradually decreases, whereas |I_{c}| increases as temperature decreases. This tendency is consistent with a temperature dependence of an effective magnetic anisotropy K_{u,eff} (decreasing at higher temperatures and increasing at lower temperatures). FIG. 8B (820) further shows that R_{AHE} levels before and after magnetization switching remain stable against temperature variation, thereby supporting both complete magnetization reversal and thermal stability of a readout signal.

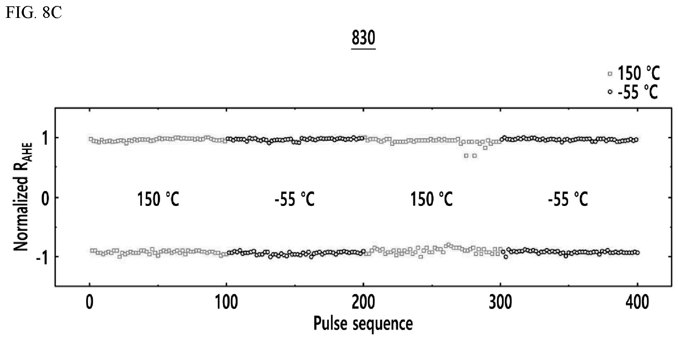

FIG. 8C (830) illustrates a result obtained by applying several hundred current-pulse sequences to the same specimen while alternately repeating thermal cycles between -55 °C and +150 °C, and plotting a normalized R_{AHE} as a function of pulse number.

FIG. 8C (830) clearly shows that the normalized R_{AHE} at each temperature exhibits only a minor deviation (within a few percent) from a reference value, and that no significant degradation is observed even after approximately 400 consecutive pulse operations. Accordingly, FIG. 8C (830) demonstrates that a platinum-zirconium-based heterojunction ensures both magnetization switching reliability and readout stability even under repeated low- and high-temperature cycling conditions.

The results of FIGS. 8A to 8C collectively present the following structure-property-operation correlation.

First, by optimizing a composition of a platinum-zirconium alloy (for example, x ≈ 16.6 at%), a spin-orbit torque efficiency is maximized, thereby significantly reducing a critical current density J_{c}.

Second, due to maintenance of perpendicular magnetic anisotropy (PMA) and stable R_{AHE} readout, low-current-driven magnetization switching is reproducibly achieved over a wide temperature range from -55 °C to +150 °C.

Furthermore, reliability testing under thermal cycling confirms that device degradation is suppressed even during long-term repetitive operation, which is advantageous for applications requiring harsh environmental tolerance, such as automotive electronics and industrial temperature specifications.

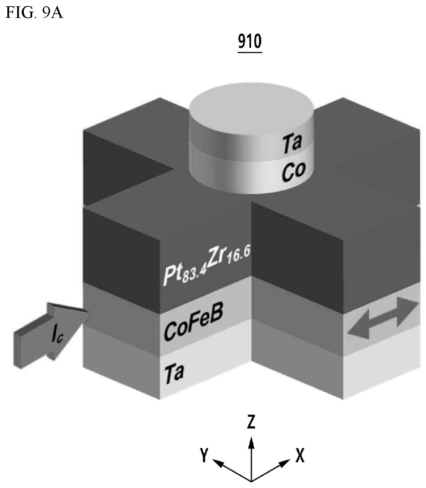

FIGS. 9A to 9C are diagrams illustrating results of analyzing magnetization switching characteristics and controllability in a field-free magnetization switching structure employing a platinum-zirconium (Pt-Zr) alloy.

FIGS. 9A to 9C include a device stacking and pattern configuration (910), and comparative results (920, 930) of current-driven magnetization switching behavior read out by a transverse anomalous Hall resistance R_{AHE}, compared according to a polarization sequence of an external magnetic field Hₓ. The coordinate ranges are illustrated as approximately -25 to +25 mA for a critical current I_{c}, approximately -20 to +20 mT for Hₓ, and approximately -2 to +6 Ω for RAHE.

FIG. 9A (910) illustrates a schematic structure of a field-free magnetization switching device. In the magnetization switching device, a magnetic layer having an in-plane magnetization (for example, CoFeB, 2 nm) is formed on a lower tantalum (Ta) seed layer (for example, 2 nm), and a platinum-zirconium alloy layer serving as a spin torque generation layer (for example, Pt_{83.4}Zr_{16.6}, 4 nm) is stacked thereon. A free magnetic layer (Co) having perpendicular magnetic anisotropy (PMA) is formed on the platinum-zirconium alloy layer, and a tantalum (Ta) capping layer is formed at an uppermost portion.

The magnetization switching device is patterned into a Hall-bar geometry, and a measurement current I_{c} is applied along an x-axis direction, while R_{AHE} is measured at transverse electrodes at an intersection region. A spin current having a polarization along a z-direction is generated at an interface between the lower in-plane-magnetized magnetic layer (CoFeB) and the platinum-zirconium alloy layer, thereby enabling spin-orbit-torque (SOT)-induced magnetization switching without an external magnetic field. Since the platinum-zirconium alloy has a high spin Hall conductivity and an appropriate resistivity, a spin current generated from an in-plane current I_{c} is efficiently injected into the free layer (Co) to form a damping-like torque, which drives magnetization switching.

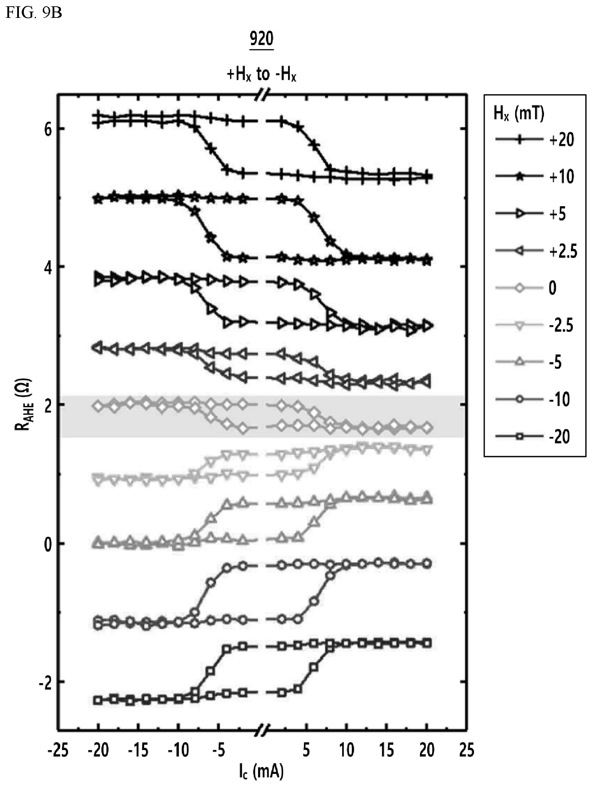

FIG. 9B (920) illustrates superposed R_{AHE}-I_{c} curves measured by sweeping the current I_{c} at each value of Hₓ while stepwise varying the external magnetic field Hₓ from +20 mT to -20 mT (+Hₓ → -Hₓ sequence). Each curve exhibits a clear step-like behavior between two stable R_{AHE} levels corresponding to upward and downward magnetization states, and as Hₓ changes from a positive (+) direction to a negative (-) direction, both polarity and magnitude of a switching critical current systematically shift.

Specifically, at +Hₓ, magnetization switching occurs at a lower critical value for one current polarity and at a higher critical value for an opposite polarity, and as an absolute value of Hₓ decreases, the two critical values approach each other. Magnetization switching is maintained even near Hₓ ≈ 0 mT.

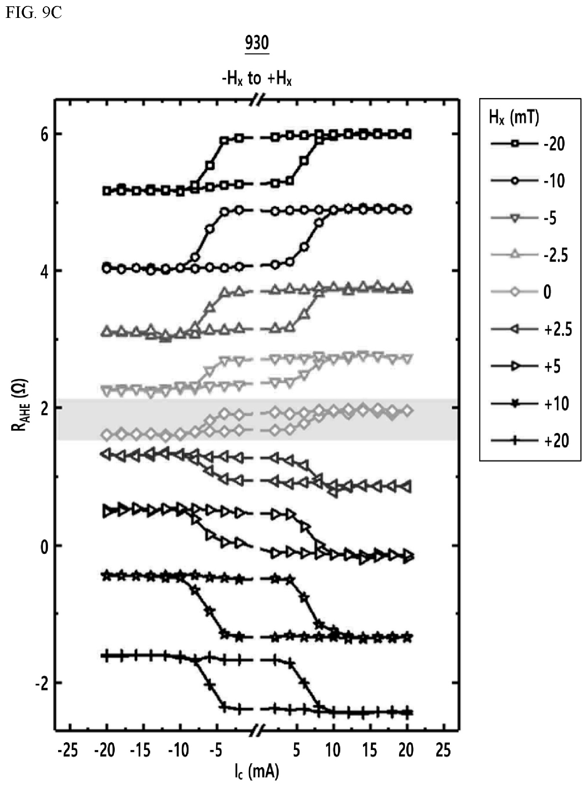

FIG. 9C (930) illustrates R_{AHE}-I_{c} curves obtained under the same specimen and measurement conditions as in FIG. 9B, while varying Hₓ in a reverse sequence from -20 mT to +20 mT (-Hₓ → +Hₓ sequence). FIG. 9C shows a symmetric behavior corresponding to that of FIG. 9B, and clearly demonstrates that, when a polarity of Hₓ is reversed, a polarity of magnetization switching is also reversed. In addition, at Hₓ = 0 mT, a polarity of magnetization switching depends on a direction of magnetization of the in-plane-magnetized magnetic layer.

The magnitudes of the critical current at the same absolute values of Hₓ are identical between the two sweep groups (920, 930), demonstrating that magnetization switching is determined by a deterministic mechanism governed by a vector sum of SOT and a bias field, rather than by thermal stochasticity. Furthermore, maintenance of magnetization switching at Hₓ = 0 mT, together with stability of R_{AHE} levels both before and after switching, indicates sufficient readout contrast and high operational reproducibility even in the absence of an external magnetic field.

When results of FIGS. 9A to 9C are considered collectively, introduction of a lower in-plane-magnetized magnetic layer (CoFeB) enables generation of a spin current having a polarization along a z-direction at an interface between the lower in-plane-magnetized magnetic layer and the platinum-zirconium alloy layer, thereby allowing SOT-induced magnetization switching without an external magnetic field.

In addition, symmetric reversal of magnetization switching curves upon sign inversion of Hₓ is consistent with a chiral Neel domain-wall-based SOT-driven model, and suggests that optimization of a critical current under field-free switching conditions can be achieved by a Pt-Zr composition (for example, Pt_{83.4}Zr_{16.6}) and layer-thickness design (for example, Pt-Zr 4 nm, CoFeB 2 nm, and optimization of a free-layer Co thickness).

Accordingly, a structure of the spin-orbit-torque-based magnetization switching device proposed herein does not require an external magnetic-field generator during bit writing, and is advantageous in terms of device integration density, power consumption, and system complexity, and is suitable for field-free write-type memory devices such as SOT-MRAM.

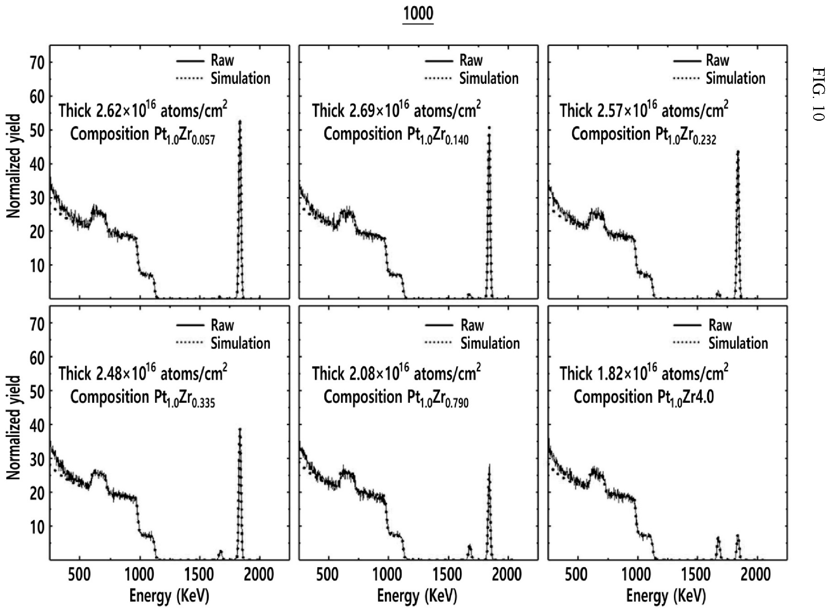

FIG. 10 is a diagram (1000) illustrating results of quantitatively verifying a zirconium (Zr) composition in a Si/SiO₂ substrate/Pt-Zr structure by Rutherford backscattering spectroscopy (RBS).

FIG. 10 compares, in pairs, experimentally measured RBS spectra (raw data, solid lines) obtained from respective samples with corresponding simulation results (dashed lines), thereby demonstrating that estimation of an atomic composition and an areal density (thickness) of the alloy is achieved with high reliability.

In each panel, a vertical axis represents a normalized scattering yield, and a horizontal axis represents an energy (keV) of backscattered He⁺ ions. According to an RBS principle, atoms having a larger atomic mass yield a higher backscattering energy. Accordingly, peaks and step features appearing in a high-energy region primarily correspond to platinum (Pt), whereas shoulder components appearing in a lower-energy region mainly correspond to zirconium (Zr). When edge positions, peak shapes, and integrated areas of the measured spectra coincide with those of the simulation, it indicates that the corresponding composition ratio and areal density (atoms/cm²) are physically valid.

An upper row of FIG. 10 (three panels) illustrates samples in a solid-solution regime having a high platinum (Pt) composition and a low zirconium (Zr) content.

An upper-left panel illustrates results for a sample labeled "Thick 2.62×10¹⁶ atoms/cm², Composition Pt_{1.0}Zr_{0.057}." The spectrum exhibits a surface peak of platinum (Pt) on a high-energy side and a gently decaying tail toward a lower-energy side, and a simulation curve almost completely overlaps with measured data. These results indicate that a solid solution in which zirconium (Zr) is substitutionally incorporated in a platinum (Pt) lattice is uniformly formed.

An upper-middle panel illustrates results for a sample labeled "Thick 2.69×10¹⁶ atoms/cm², Composition Pt_{1.0}Zr_{0.0140}." A zirconium-related shoulder component increases in an intermediate energy region, and the simulation precisely reproduces this feature, indicating that compositional uniformity is maintained even as a zirconium (Zr) fraction increases.

An upper-right panel illustrates results for a sample labeled "Thick 2.57×10¹⁶ atoms/cm², Composition Pt_{1.0}Zr_{0.232}." A zirconium-related contribution becomes more pronounced and increases in relative weight compared to a platinum (Pt) peak, and the simulation accurately captures corresponding shifts in peak position and intensity.

A lower row of FIG. 10 (three panels) illustrates samples having a higher zirconium (Zr) content.

A lower-left panel illustrates results for a sample labeled "Thick 2.48×10¹⁶ atoms/cm², Composition Pt_{1.0}Zr_{0.335}." A zirconium-related shoulder further increases, while a relative intensity of a platinum (Pt) surface peak slightly decreases. Nevertheless, excellent agreement between measured and simulated spectra confirms reliability of estimated thickness and composition.

A lower-middle panel illustrates results for a sample labeled "Thick 2.08×10¹⁶ atoms/cm², Composition Pt_{1.0}Zr_{0.790}." A zirconium contribution becomes dominant, and a spectral centroid shifts toward a lower-energy side. The simulation accurately reproduces such an energy-axis shift and a change in relative intensity, supporting that a target alloy composition is achieved even at a high zirconium (Zr) content.

A lower-right panel illustrates results for a sample labeled "Thick 1.82×10¹⁶ atoms/cm², Composition Pt_{1.0}Zr_{4.0}." Corresponding to an extremely high zirconium (Zr) ratio, a platinum (Pt) contribution is significantly reduced, and zirconium-related signals occupy a major portion of the spectrum. Strong agreement between measured and simulated spectra confirms that composition and areal density parameters are physically reasonable.

In each panel of FIG. 10, a label "Thick" denotes an areal density of the alloy. Even when a composition varies under identical process conditions, the areal density remains within a relatively narrow range of approximately 1.82×10¹⁶ to 2.69×10¹⁶ atoms/cm², indicating that a total deposited material amount is well controlled during a deposition process. A combination of the areal density and composition corresponds to an actual thickness of approximately 5 nm, which is consistent with a target thickness required for device stacking.

Since edge positions of measured spectra coincide with those of simulations across an entire energy range, FIG. 10 indicates that an interface between a platinum-zirconium alloy layer and a Si/SiO₂ substrate is well defined, without significant interfacial reactions or severe compositional gradients. If strong interdiffusion or compositional grading were present, backscattering edges and shoulder features would broaden or exhibit asymmetric distortion; however, such behavior is not observed.

Further, as a zirconium (Zr) composition increases, a relative intensity in a mid-to-low energy region systematically increases with respect to a platinum (Pt) surface peak, quantitatively confirming that a zirconium content in the alloy increases as intended. In addition, residuals between measured data and simulation results are small and consistent for all samples, indicating that composition ratios (Pt:Zr) and areal densities derived through an RBS fitting process are statistically reliable.

Accordingly, FIG. 10 confirms that a composition of a platinum-zirconium alloy can be precisely controlled over a wide range (e.g., from Pt_{1.0}Zr_{0.057} to Pt_{1.0}Zr_{4.0}) by adjusting a zirconium (Zr) flux during deposition.

Since reproducibility of compositional control is verified by RBS, compositional dependences of microstructure, resistivity, and spin-orbit torque efficiency described above can be directly correlated with an actual alloy composition. Furthermore, confirmation of a clear interface and compositional uniformity supports physical prerequisites required for efficient spin-current injection and maintenance of perpendicular magnetic anisotropy, including homogeneous scattering and a stable interfacial state.

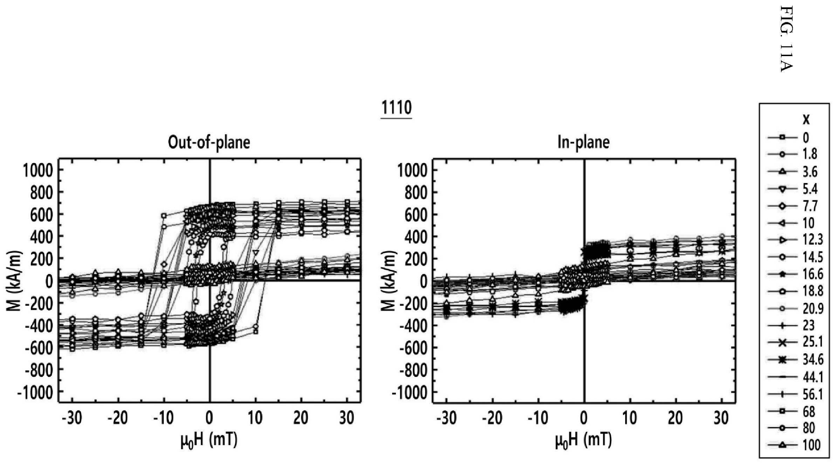

FIGS. 11A to 11D are diagrams illustrating magnetic hysteresis loops, effective saturation magnetization analysis, and behavior of effective saturation magnetization as a function of zirconium composition in structures employing a platinum-zirconium alloy.

FIG. 11A (1110) illustrates magnetic hysteresis loops of a Ta (2)/Pt-Zr (5)/Co (1.2)/Ta (2) structure (units: nm).

The left panel of FIG. 11A shows results obtained when an external magnetic field is applied in an out-of-plane direction of a thin film, and the right panel shows results obtained when the external magnetic field is applied in an in-plane direction of the thin film.

In FIG. 11A, magnetization curves M (kA/m) versus µ₀H (mT) are overlaid for a series of samples in which a zirconium composition x (at%) is varied among 0, 1.8, 3.6, 5.4, 7.7, 10, 12.3, 14.5, 16.6, and 18.8.

The out-of-plane curves shown in the left panel of FIG. 11A exhibit square-shaped magnetic hysteresis loops in which a remanent magnetization is close to a saturation magnetization and a coercive field (H_{c}) ranges from several mT to several tens of mT, thereby confirming that a free layer (Co) stably possesses perpendicular magnetic anisotropy (PMA).

In contrast, the in-plane curves shown in the right panel of FIG. 11A exhibit an almost linear and gentle slope with difficulty in reaching saturation. This indicates that an easy axis of magnetization lies in a perpendicular direction, and suggests that strong interfacial magnetic anisotropy (Kₛ) generated at a Pt-Zr (5)/Co (1.2) interface (units: nm) supports the PMA.

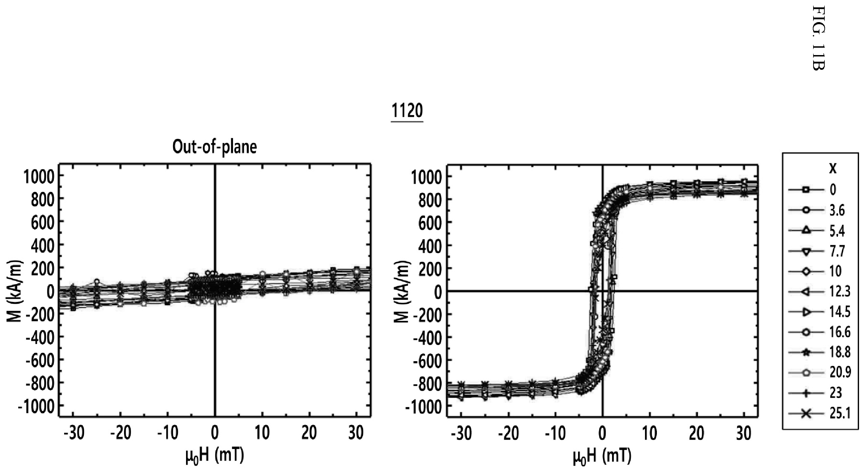

FIG. 11B (1120) illustrates magnetic hysteresis loops of a Ta (2)/Pt-Zr (5)/Co (3)/Ta (2) structure (units: nm).

In FIG. 11B, the out-of-plane curve shows almost no hysteresis and exhibits a gentle linear behavior, whereas the in-plane curve exhibits a square-shaped hysteresis loop.

This indicates that, as a thickness of the free layer (Co) increases from 1.2 nm to 3 nm, a relative contribution of interfacial magnetic anisotropy decreases while volume magnetic anisotropy and a demagnetizing field become dominant, thereby shifting an easy axis of magnetization to an in-plane direction. Accordingly, FIG. 11B demonstrates that a transition between perpendicular magnetic anisotropy and in-plane magnetic anisotropy can be controlled by a thickness of the Co free layer.

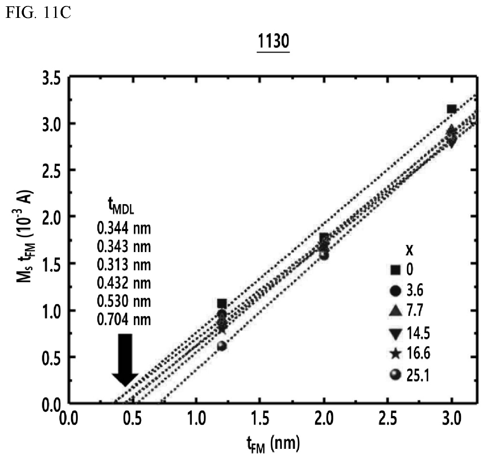

FIG. 11C (1130) illustrates results for analyzing effective saturation magnetization and a magnetic dead layer (MDL) in a Pt-Zr/Co heterostructure.

In FIG. 11C, a horizontal axis represents a free-layer (Co) thickness t_{FM} (nm), and a vertical axis represents M_{s,eff} × t_{FM} (10⁻³ A). Data measured for different zirconium compositions x (at%) are well fitted by linear relationships, and a thickness of the magnetic dead layer (t_{MDL}) is extracted from a y-intercept (a negative intersection extrapolated to an origin) of each fitted line.

In FIG. 11C, t_{MDL} is calculated to be in a range of approximately 0.31 nm to 0.70 nm depending on composition (example values: 0.313 nm, 0.344 nm, 0.343 nm, 0.432 nm, 0.530 nm, and 0.704 nm), and a slope of each fitted line corresponds to an effective saturation magnetization M_{s,eff} (approximately 1.0-1.1 MA/m).

These results indicate that a thin nonmagnetic or weakly magnetic layer exists at an interface between a platinum-zirconium alloy and cobalt, such that an effective magnetic thickness is given by t_{FM} - t_{MDL}, and also suggest that M_{s,eff} is maintained without significant variation even as the composition changes.

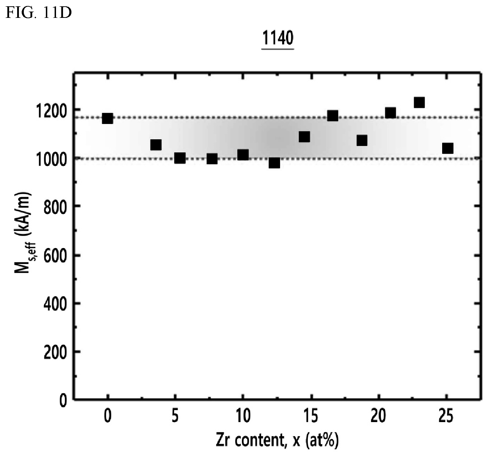

FIG. 11D (1140) illustrates behavior of effective saturation magnetization M_{s,eff} (kA/m) as a function of a zirconium composition x (at%).

In FIG. 11D, M_{s,eff} remains nearly constant (for example, around 1000 kA/m) over an entire range from x = 0 at% to approximately x = 25 at%, and does not significantly deviate from a reference value indicated by a vertical dashed line.

This indicates that introduction of zirconium (Zr) into the platinum-zirconium alloy does not substantially reduce Mₛ of the free layer (Co), and that stability of M_{s,eff} is secured even when an alloy composition is optimized. In addition, a slight dispersion shown in FIG. 11D corresponds to process tolerances and sample-to-sample variations, and indicates that there is no systematic composition-dependent decreasing or increasing trend.

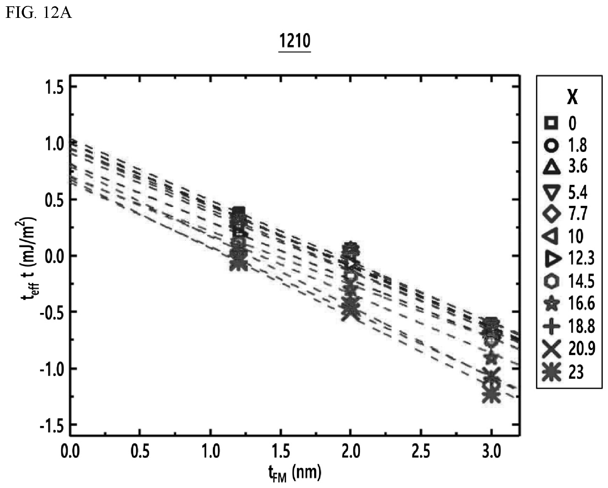

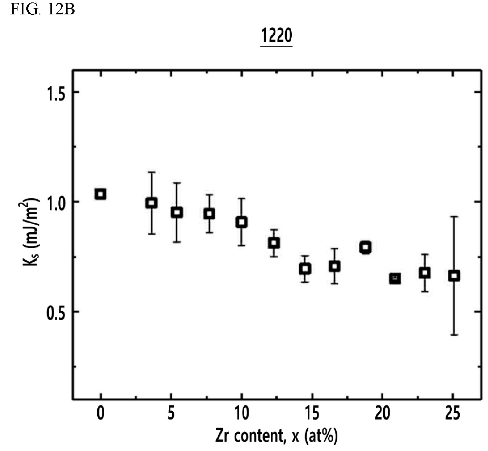

FIGS. 12A and 12B are diagrams illustrating results of analyzing magnetic anisotropy at an interface between a platinum-zirconium alloy and a free layer based on perpendicular magnetic anisotropy energy.

In particular, FIG. 12A (1210) illustrates variations of a product of an effective magnetic anisotropy constant and a free-layer thickness (K_{eff} × t) as a function of a free-layer thickness t_{FM} in a heterojunction composed of a platinum-zirconium alloy and a free layer (Co), for each zirconium composition x (at%).

In FIG. 12A, a horizontal axis represents the free-layer thickness t_{FM} (nm), and a vertical axis represents K_{eff} × t (mJ/m²), and dashed-line fittings correspond to respective sample groups having zirconium compositions of x = 0, 1.8, 3.6, 5.4, 7.7, 10, 12.3, 14.5, 16.6, 18.8, 20.9, and 23 at%.

FIG. 12A shows that, for all compositions, K_{eff} × t decreases linearly as the free-layer thickness t_{FM} increases, and that, for some compositions, a region appears in which K_{eff} × t transitions to zero or less beyond a certain thickness.

Such linearity observed in FIG. 12A is based on the following standard relationship. [Equation 3] ${K}_{eff} \times t = {K}_{s} + \left({K}_{v}+1/{2}_{μ 0}{Ms}^{2}\right) {t}_{FM}$

In [Equation 3], Kₛ represents an interfacial (surface) magnetic anisotropy energy (mJ/m²), Kᵥ represents a volume (bulk) magnetic anisotropy energy density (MJ/m³), and Mₛ represents an effective saturation magnetization (A/m).

Accordingly, a y-intercept of a linear fit shown in FIG. 12A corresponds to Kₛ, and a slope corresponds to (Kᵥ - 1/2 µ₀ Mₛ²). The negative slope observed in FIG. 12A indicates that, in most thin-film free layers, a shape (demagnetization) energy term (1/2 µ₀ Mₛ²) is dominant, thereby rendering the effective volume term negative.

In FIG. 12A, a thickness t* at which each composition-dependent straight line intersects a K_{eff} × t = 0 axis corresponds to a critical thickness for perpendicular magnetic anisotropy. A smaller value of t* indicates that perpendicular magnetic anisotropy can be maintained even in a thinner free layer.

FIG. 12A clearly shows that, as the zirconium composition increases, an intercept (Kₛ) of the straight line decreases, and as a result, t* increases, indicating that a stability window for maintaining perpendicular magnetic anisotropy becomes narrower.

For reference, t* denotes a critical thickness related to a film thickness.

For example, in a magnetic thin-film structure, perpendicular magnetic anisotropy (PMA) is maintained when a thickness is below t*, whereas when the thickness exceeds t*, a volume magnetic anisotropy becomes dominant, resulting in a transition to in-plane magnetic anisotropy. That is, t* represents a maximum thickness at which perpendicular magnetic anisotropy can be sustained.

FIGS. 12A and 12B are diagrams illustrating results of analyzing magnetic anisotropy at an interface between a platinum-zirconium alloy and a free layer based on perpendicular magnetic anisotropy energy.

In particular, FIG. 12A is a diagram (1210) illustrating variations of a product of an effective magnetic anisotropy constant and a free-layer thickness (K_{eff} × t) as a function of a free-layer thickness (t_{FM}) for each zirconium composition (x, at%) in a heterojunction composed of a platinum-zirconium alloy and a free layer (Co).

In FIG. 12A, a horizontal axis represents the free-layer thickness t_{FM} (nm), and a vertical axis represents K_{eff} × t (mJ/m²). Each dashed linear fitting corresponds to a sample group having zirconium compositions of x = 0, 1.8, 3.6, 5.4, 7.7, 10, 12.3, 14.5, 16.6, 18.8, 20.9, and 23 at%, respectively.

FIG. 12A shows that K_{eff} × t decreases linearly as t_{FM} increases for all compositions, and, for some compositions, a region appears in which K_{eff} × t transitions to zero or less beyond a specific thickness. Such linearity in FIG. 12A is based on the following standard relationship. [Equation 3] ${K}_{eff} \times t = {K}_{s} + \left({K}_{v}+1/{2}_{μ 0}{Ms}^{2}\right) {t}_{FM}$

In [Equation 3], Kₛ denotes an interfacial (surface) magnetic anisotropy energy (mJ/m²), Kᵥ denotes a volumetric (bulk) magnetic anisotropy energy density (MJ/m³), and Mₛ denotes an effective saturation magnetization (A/m). Accordingly, a y-intercept of each straight line shown in FIG. 12A corresponds to Kₛ, and a slope thereof corresponds to (Kᵥ - 1/2µ₀Mₛ²). A negative slope observed in FIG. 12A indicates that, in most thin-film free layers, a shape (demagnetization) energy term (1/2µ₀Mₛ²) dominates, such that a volumetric term is effectively rendered negative.

In FIG. 12A, an intersection thickness t at which each composition-dependent straight line intersects a K_{eff} × t = 0 axis corresponds to a critical thickness for perpendicular magnetic anisotropy. As t decreases, perpendicular magnetic anisotropy is maintained even in a thinner free layer.

FIG. 12A clearly shows that, as a zirconium composition increases, an intercept (Kₛ) of the straight line decreases, and as a result, a critical thickness t* increases, thereby narrowing a window in which perpendicular magnetic anisotropy is maintained.

For reference, t* denotes a critical thickness related to a film thickness. For example, in a magnetic thin-film structure, perpendicular magnetic anisotropy (PMA) is maintained when a thickness is equal to or less than a specific value, whereas when the thickness exceeds t*, volumetric magnetic anisotropy becomes dominant and an anisotropy transitions to an in-plane magnetic anisotropy. That is, t* represents a maximum thickness at which perpendicular magnetic anisotropy can be maintained.

FIG. 12B is a diagram (1220) illustrating interfacial magnetic anisotropy energy Kₛ extracted through the linear fitting procedure of FIG. 12A and plotted as a function of the zirconium composition (x, at%).

In FIG. 12B, a horizontal axis represents the zirconium (Zr) composition x (at%), and a vertical axis represents Kₛ (mJ/m²). Each data point indicates a fitting intercept obtained by a least-squares method, and error bars represent a corresponding standard deviation. FIG. 12B shows that Kₛ has a maximum value (for example, approximately 1.1-1.3 mJ/m²) at x = 0 at%, and gradually decreases as x increases, reaching a range of approximately 0.6-0.8 mJ/m² in a region of x ≈ 15-20 at%.

Results of FIG. 12B quantitatively demonstrate that strong Kₛ is provided by 5d-3d orbital hybridization originating from a Pt/Co interface, whereas, when zirconium (Zr) is substituted into a platinum (Pt) lattice, (i) a face-centered cubic (fcc) (111) texture and long-range order of platinum (Pt) are weakened, (ii) a relative fraction of a Pt-Zr interfacial configuration decreases, and (iii) orbital hybridization at a Zr/Co interface is relatively weak, such that a contribution of perpendicular magnetic anisotropy originating from interfacial spin-orbit coupling is reduced.

Analytical procedures of FIGS. 12A and 12B are as follows. First, for each composition x, free layers (Co) having multiple thicknesses are fabricated, and K_{eff} × t is calculated from out-of-plane and in-plane M-H loop measurements. Calculation of K_{eff} is performed using a magnetic hysteresis loop area method, and the magnetic hysteresis loops are obtained by measurements using a vibrating sample magnetometer. Second, linear fitting is applied to K_{eff} versus free-layer thickness data to extract an intercept (Kₛ) and a slope (Kᵥ-related term). Third, a Kₛ-x curve is plotted over an entire composition range and compared as shown in FIG. 12B. In this process, identical measurement and analysis protocols are applied to ensure objectivity of compositional comparison.

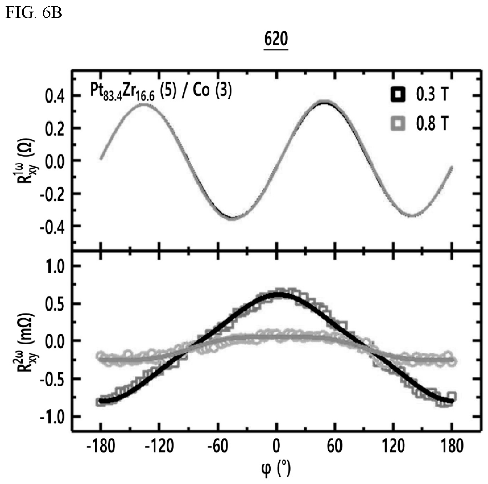

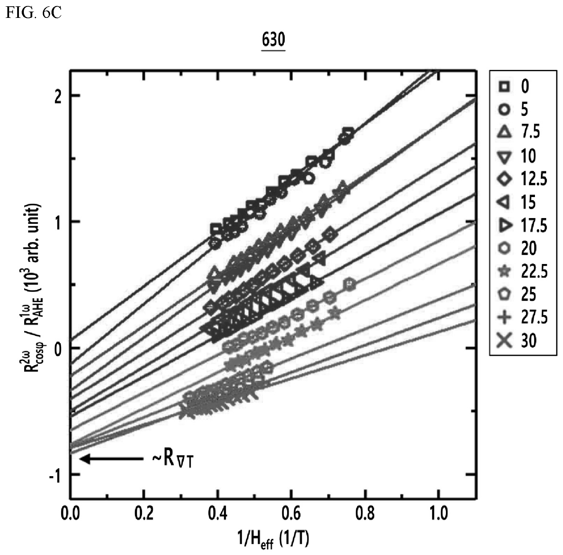

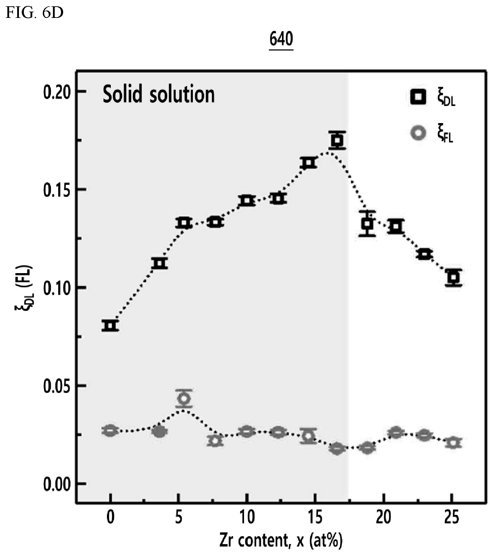

Technical implications derived from results of FIGS. 12A and 12B are as follows. First, a range in which perpendicular magnetic anisotropy is maintained is more favorable when a zirconium composition is lower and a free layer is thinner. Second, in a magnetization-switching structure, even when the same spin torque layer (Pt-Zr, 5 nm) is used, perpendicular magnetic anisotropy retention and a low critical current density (J_{c}) can be simultaneously achieved by optimizing both a free-layer thickness t_{FM} and a zirconium (Zr) composition x. Third, a decrease in Kₛ is consistently correlated with weakening of a Dzyaloshinskii-Moriya interaction (DMI) in FIG. 5C, reduction of K_{eff} in FIG. 5B, and an optimal composition window for spin-orbit torque efficiency in FIGS. 6 and 7 (for example, x ≈ 5-18.8 at%), thereby supporting that an intrinsic spin Hall effect is dominant and an interfacial contribution is auxiliary. Fourth, since a critical thickness t* can be approximated as t* = Kₛ / (µ₀ Mₛ² - Kᵥ), a decrease in Kₛ confirmed in FIG. 12B directly leads to an increase in t*, thereby quantitatively explaining loss of perpendicular magnetic anisotropy in a thicker free layer.

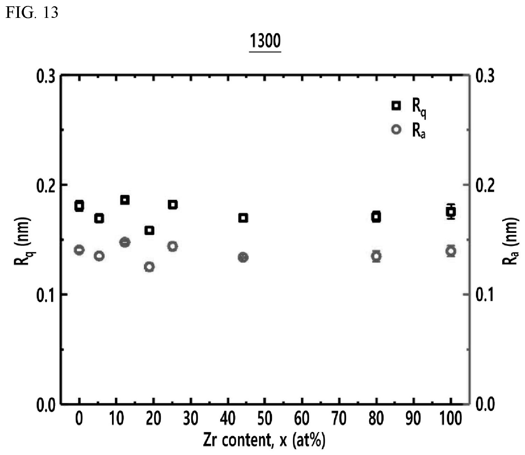

FIG. 13 is a diagram (1300) illustrating results of quantitatively evaluating surface roughness of a Ta (2)/Pt-Zr (5) stacked structure (units: nm).

In FIG. 13, a horizontal axis represents a zirconium composition x (at%), a left vertical axis represents a root-mean-square surface roughness R_{q} (nm), and a right vertical axis represents an arithmetic average surface roughness Rₐ (nm). Data markers are distinguished as squares for R_{q} and circles for Rₐ, and all samples were obtained under identical deposition and measurement conditions.

As shown in FIG. 13, both R_{q} and Rₐ are maintained at very low values (approximately 0.1-0.2 nm) over an entire composition range, and no clear monotonic increasing or decreasing trend with increasing composition is observed.

More specifically, R_{q} is distributed in a range of approximately 0.16-0.19 nm for most compositions, and Rₐ is distributed in a range of approximately 0.12-0.15 nm. Although local deviations are observed at some extreme compositions (for example, x ≈ 0 or x ≈ 90-100 at%), absolute values thereof are still limited to 0.2 nm or less, confirming that surfaces are generally very flat.

In addition, a relationship of R_{q} ≥ Rₐ is maintained for all compositions, and a ratio R_{q}/Rₐ remains within a narrow range close to 1, which is a characteristic of an ideal Gaussian surface. This indicates that a surface height distribution is uniform and that abnormal spikes or pinholes are absent.

Definitions of roughness parameters used in the present specification are as follows.

An arithmetic average roughness Rₐ is defined as an average value of absolute height deviations |zᵢ| within a sampling area, and is expressed as ${R}_{a} = \frac{1}{N} {\sum }_{i = 1}^{N} \left|{z}_{i}\right|$.

A root-mean-square roughness R_{q} is defined as a square root of a mean of squared height deviations, and is expressed as ${R}_{q} = \sqrt{\frac{1}{N} {\sum }_{i = 1}^{N} {z}_{i}^{2}}$.

Here, zᵢ denotes a height deviation of each data point with respect to a reference plane, and N denotes a number of data points. R_{q} is more sensitive to large surface undulations, whereas Rₐ intuitively represents an overall average roughness.

As shown in FIG. 13, even when compositional variation (x) associated with platinum-zirconium alloying is introduced, flatness of an upper surface can be maintained substantially constant.

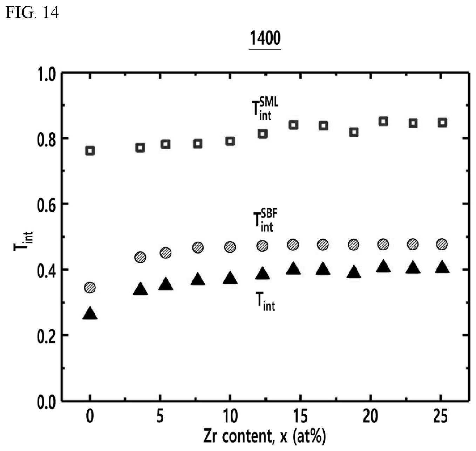

FIG. 14 is a diagram (1400) illustrating results of quantitatively evaluating a spin transparency at an interface between a platinum-zirconium (Pt-Zr) alloy and a free layer (Co) in a Ta (2)/Pt-Zr (5)/Co (3)/Ta (2) stacked structure (units: nm).

In FIG. 14, the spin transparency *T*ᵢₙₜ is approximated as a product of two independent interfacial mechanisms, namely spin backflow (SBF) and spin memory loss (SML) at the interface, and is defined as ${T}_{int} \approx {T}_{int}^{SBF} \times {T}_{int}^{SML}$.

First, ${T}_{int}^{SBF}$ is calculated using Equation (4) derived from a diffusion-drift model. In this calculation, a thickness *d*_{HM} of a heavy metal (HM) layer, a spin conductance *G*_{HM} of the HM layer, and an interfacial spin-mixing conductance *G*_{HM/FM} at an HM/FM interface are taken into account, and ${T}_{int}^{SBF}$ is obtained through [Equation 4]. [Equation 4] ${T}_{int}^{SBF} = \frac{1 - sech \left(d/{λ}_{s}\right)}{1 + {G}_{HM} tanh \left(d/{λ}_{s}\right) / \left(2 {G}_{HM / FM}^{↑ ↓}\right)}$

In [Equation 4], λₛ denotes a spin diffusion length of a heavy metal layer.

The spin diffusion length λₛ is estimated by assuming that it is linearly proportional to the longitudinal electrical conductivity σₓₓ, based on the Elliott-Yafet spin relaxation model.

As a result, λₛ of a pure platinum (Pt) sample is calculated to be approximately 2.632 nm, whereas λₛ is reduced to approximately 0.570 nm at a zirconium (Zr) content of x = 23 at%.

In addition, λₛ of a Pt_{83.4}Zr_{16.6} sample, which is identified as an optimal performance composition, is calculated to be approximately 0.642 nm, which is consistent with a value measured based on a drift-diffusion model.

Meanwhile, since a thickness of the platinum-zirconium alloy layer is smaller than an electron mean free path of platinum (Pt), charge and spin transport at an interface is interpreted as being governed by a Sharvin conduction regime.

Accordingly, ${G}_{Pt - Zr / Co}^{↑ ↓}$ is assumed to be identical to a Sharvin conductance, and both ${G}_{Pt - Zr / Co}^{↑ ↓}$ and ***G*_{Pt-Zr}** are calculated by reflecting their dependence on an electronic density of states (band filling).

Such assumptions are employed in the estimation of ${T}_{int}^{SBF}$.

According to the results shown in FIG. 14, as the zirconium (Zr) content x increases from 0 to 25 at%, the three physical quantities vary as follows.

First, ${T}_{int}^{SML}$ gradually increases from around 0.76 to approximately 0.82-0.84.

This behavior indicates that spin non-conserving scattering (spin memory loss) at the interface between the platinum-zirconium alloy and cobalt is limited, and that the interfacial quality or spin preservation is maintained or slightly improved despite zirconium (Zr) alloying.

Next, ${T}_{int}^{SBF}$ starts at approximately 0.35 and increases significantly to about 0.45-0.46.

This increase arises because Zr alloying modifies both the effective spin conductivity and the spin diffusion length λₛ of platinum (Pt), thereby suppressing spin backflow of the spin current injected into the interface. The previously discussed reduction trend of λₛ and the applied conductivity model provide the physical basis for this interpretation.

As a result, the total spin transparency Tᵢₙₜ, defined as the product of these two effects, increases from approximately 0.27 to about 0.39-0.40.

Accordingly, the fraction of spin current that actually transmits across the interface and is injected into the free layer is markedly enhanced with increasing zirconium (Zr) content.

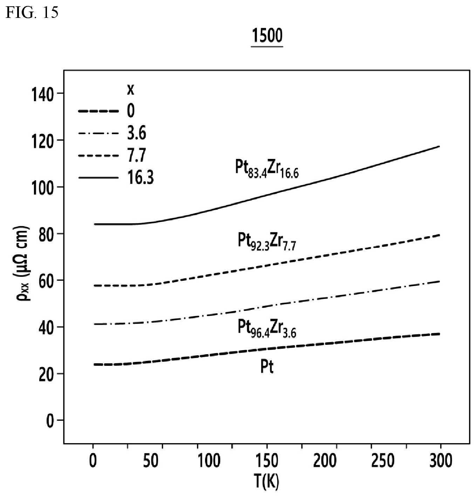

FIG. 15 is a diagram 1500 illustrating the temperature-dependent resistivity of the alloy measured using a four-point probe method.

More specifically, FIG. 15 shows the resistivity of a platinum-zirconium alloy estimated as a function of temperature using a four-point probe method in a Ta (2)/Pt-Zr (5)/Co (3)/Ta (2) thin-film stack (units: nm).

For the temperature-dependent resistivity measurement, the total resistance of the sample was measured while sweeping the temperature from 5 K to 300 K using the four-point probe method on the same stack of Ta (2)/Pt-Zr (5)/Co (3)/Ta (2) (units: nm).

In the analysis, current partitioning was evaluated under the assumption that no current flows through the capping layer (Ta 2 nm). The seed layer tantalum (Ta) with a resistivity of 720 µΩ·cm, the platinum-zirconium alloy layer, and the free layer cobalt (Co) with a resistivity of 41 µΩ·cm were modeled as a parallel resistor network. Based on this model, the fraction of the total current distributed into the platinum-zirconium layer was calculated, and the intrinsic resistivity ρₓₓ(T) of the alloy layer was back-calculated.

The graph in FIG. 15 presents representative compositions (for example, x = 0, 3.6, 7.7, and 16.6 at%), showing that ρₓₓ monotonically increases with increasing temperature, indicating metallic transport behavior.

The residual resistivity at low temperature (approximately 5 K) increases with increasing zirconium (Zr) content, reflecting enhanced disorder scattering (alloy scattering) due to alloying.

At higher temperatures, phonon scattering additionally contributes, resulting in an increase of ρₓₓ for all compositions, with both the slope and the absolute value being larger for samples with higher Zr content.

These trends are consistent with typical electrical transport characteristics of metallic alloys, in which alloy scattering and phonon scattering are superimposed, as compared with a pure platinum (Pt) single layer.

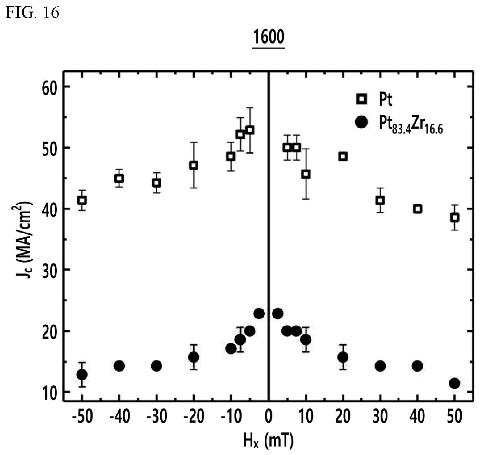

FIG. 16 is a diagram 1600 illustrating results of measurements of magnetization switching current density as a function of an external magnetic field for different zirconium compositions in a Ta (2)/Pt-Zr (5)/Co (1.2)/Ta (2) structure (units: nm).

The samples measured in FIG. 16 consist of a Ta (2)/Pt-Zr (5)/Co (1.2)/Ta (2) stack sequentially formed on a Si/SiO₂ substrate. The lower tantalum (Ta) layer serves as a seed layer, the platinum-zirconium layer functions as a heavy-metal alloy generating spin current, the cobalt (Co) layer serves as a magnetic free layer, and the upper tantalum (Ta) layer acts as a capping layer. The composition of the platinum-zirconium alloy was controlled by co-sputtering a platinum (Pt) target and a zirconium (Zr) target.

The magnetization switching current density J_{c} was determined by applying current pulses along the in-plane x-direction in a Hall bar (or cross) pattern, while varying an external magnetic field Hₓ parallel to the current direction in the range from -50 mT to +50 mT, and reading changes in the anomalous Hall resistance R_{AHE} before and after the pulse application.

In this measurement, the magnitude of Hₓ was stepwise varied from 2.5 mT to 50 mT, and the switching polarity and threshold current behavior were comparatively evaluated.

In FIG. 16, the horizontal axis represents the assist magnetic field Hₓ (mT), and the vertical axis represents the magnetization switching threshold current density J_{c} (MA/cm²). Square symbols denote a reference Pt/Co sample without zirconium addition (Pt₁₀₀Zr₀/Co), while circular symbols denote a Pt_{83.4}Zr_{16.6}/Co sample. In both data sets, J_{c} decreases as the absolute value of Hₓ increases, and the switching branch reverses depending on the sign of Hₓ.

At Hₓ = ±50 mT, the J_{c} of the reference Pt/Co sample was measured to be approximately 39.64 ± 2.832 MA/cm².

In contrast, the J_{c} of the Pt_{83.4}Zr_{16.6}/Co sample was reduced by approximately a factor of three under the same condition, reaching roughly 10-13 MA/cm² (approximately 12 MA/cm² in the graph). This reduction is attributed to enhanced effectiveness of spin-orbit torque, particularly the damping-like torque, resulting from the introduction of zirconium (Zr).

That is, as the magnitude of Hₓ increases, symmetry breaking lowers the switching barrier, leading to a reduction in J_{c}, thereby reaffirming a general characteristic of spin-orbit-torque-driven magnetization switching.

Furthermore, introducing Zr at approximately 16.6 at% reduces Jₑ to about one-third of that of the reference Pt/Co sample under the same Hₓ, which is advantageous for reducing driving power, mitigating thermal stress, and improving cell reliability.

The stacked structure and fabrication method used in the present invention are implemented by a general-purpose sputtering process compatible with memory device (MRAM-type) fabrication, thereby offering high scalability toward circuit integration environments.

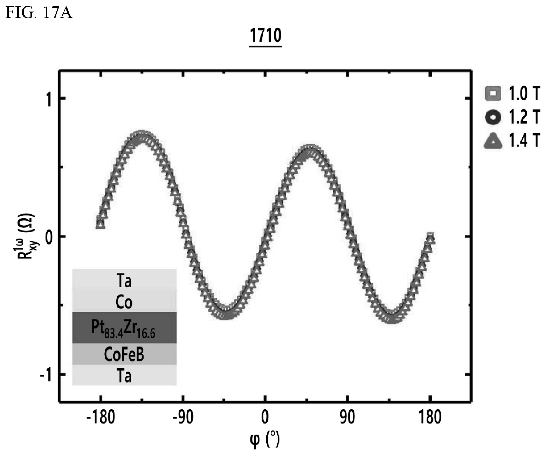

FIGS. 17A to 17E relate to quantification of a spin current having z-axis polarization generated in a field-free magnetization switching structure of Ta (2)/CoFeB (2)/Pt-Zr (4)/Co (1.2)/Ta (2) (units: nm).

FIG. 17A illustrates 1710 variations of a first harmonic signal (1st harmonic signal, V1ω) measured in the above structure as a function of an applied magnetic field angle ψ.

The external magnetic field Hₑₓₜ was varied in a range from 1.0 T to 1.8 T, and alignment of a magnetic anisotropy axis and a phase relationship between magnetization and an injected current were confirmed based on amplitude changes of the first harmonic signal.

The first harmonic component mainly consists of combined contributions from an ordinary Hall effect and an anomalous Hall effect associated with resistance variations, and is used as a reference signal representing an equilibrium magnetization response.

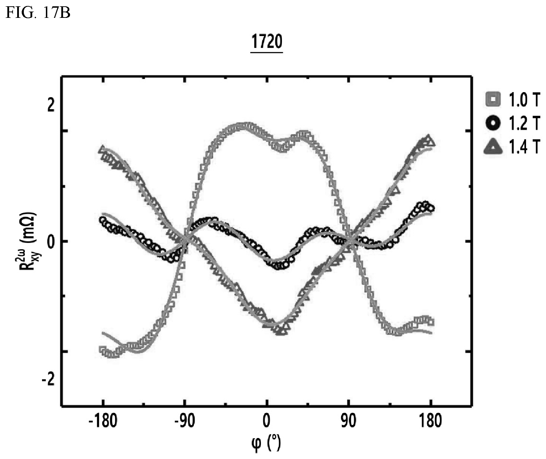

FIG. 17B illustrates, at 1720, a second harmonic signal (2nd harmonic signal, V_{2_{ω}}) measured in the same structure as a function of an angle ψ.

The external magnetic field was also varied within a range from 1.0 T to 1.8 T, and the measured second harmonic signal was analyzed based on [Equation 5] to decompose the signal into spin-current components having a y-direction polarization (y-polarized) and a z-direction polarization (z-polarized), respectively.

Since the second harmonic signal reflects oscillatory components of magnetization induced by spin-orbit torque, decomposition of the second harmonic signal enables identification and separation of respective contributions of spin-current components in each polarization direction.

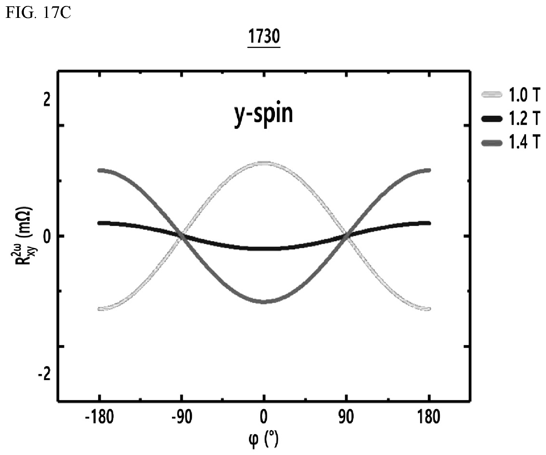

FIG. 17C illustrates, at 1730, a spin-current component having a y-direction polarization extracted from the above analysis results.

In this case, angular dependence with respect to the external magnetic field follows a cosψ functional form, indicating that a spin polarization is generated perpendicular to a direction in which an electric current flows (an in-plane direction).

The y-direction polarized spin-current component acts as a primary contribution to a damping-like torque and controls an in-plane rotational component during a magnetization switching process of a free layer.

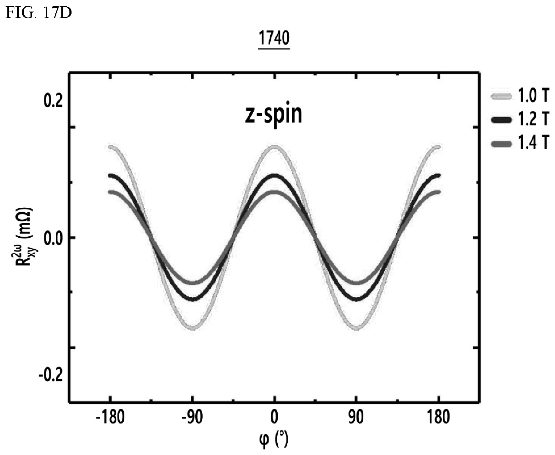

FIG. 17D illustrates, at 1740, results of extracting a z-direction polarized spin-current component.

In this case, angular dependence with respect to the external magnetic field is expressed by a cos2ψ function, indicating that the spin current is polarized in a perpendicular direction and directly induces z-axis reversal of magnetization of a free layer.

Such z-direction spin polarization is induced by structural asymmetry and imbalance of a Rashba potential at an interface, and constitutes a core mechanism enabling field-free magnetization switching in the structure of the present invention.

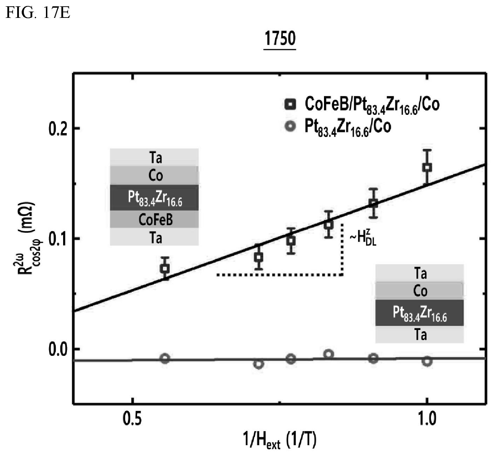

FIG. 17E illustrates, at 1750, a graph plotting the cos2ψ dependence obtained in FIG. 17D as a function of an inverse of an external magnetic field (1/Hₑₓₜ), in which a slope represents an effective field ${H}_{DL}^{z}$ induced by a z-direction polarized spin current.

A magnitude of ${H}_{DL}^{z}$ is directly used for quantification of a spin-orbit torque efficiency ξ_{DL}, and experimental results confirm that the z-axis polarized spin current in the above structure exhibits a high ξ_{DL} value of approximately 0.175.

Accordingly, FIGS. 17A to 17E provide experimental evidence supporting field-free switching in which magnetization reversal is achievable without an external magnetic field, and empirically demonstrate that the z-axis polarized spin current functions as a decisive torque component inducing magnetization reversal of a free layer (Co).

In the graphs, square symbols represent an effective magnetic field generated by a z-direction polarized spin current in a field-assisted magnetization switching structure of Ta (2)/CoFeB (2)/Pt-Zr (4)/Co (1.2)/Ta (2) (units: nm), whereas circular symbols represent an effective magnetic field generated by a z-axis polarized spin current in a comparative structure of Ta (2)/Pt-Zr (6)/Co (3)/Ta (2) (units: nm).

In the field-assisted magnetization switching structure of Ta (2)/CoFeB (2)/Pt-Zr (4)/Co (1.2)/Ta (2) (units: nm), a non-zero slope is observed, indicating formation of an effective magnetic field of approximately 1.51 Oe originating from a z-axis polarized spin current.

In contrast, in the comparative Ta (2)/Pt-Zr (6)/Co (3)/Ta (2) (units: nm) structure, the slope is almost absent, indicating that a z-axis polarized spin current is not generated. [Equation 5] $\begin{matrix}{R}_{xy}^{2 ω} = \left[{R}_{AHE}\frac{{H}_{DL}^{x}}{2 {H}_{eff}}\right] sin φ + \left[-{R}_{PHE}\frac{{H}_{FL}^{x}}{2 {H}_{eff}}\right] sin φ cos 2 φ \\ + \left[{R}_{AHE}\frac{{H}_{DL}^{y}}{{H}_{eff}}\right] cos φ + \left[2{R}_{AHE}\frac{{H}_{FL}^{y} + {H}_{Oe}}{{H}_{ext}}\right] \left(2{cos}^{3}φ-cos φ\right) \\ - \left[2{R}_{PHE}\frac{{H}_{DL}^{z}}{{H}_{ext}}\right] cos 2 φ + {R}_{AHE} \frac{{H}_{FL}^{z}}{{H}_{eff}}\end{matrix}$

In [Equation 5], ${H}_{DL}^{x} , {H}_{DL}^{y}$, and ${H}_{DL}^{z}$ denote effective magnetic fields arising from damping-like torques generated by spin currents having x-axis, y-axis, and z-axis polarizations, respectively.${H}_{FL}^{x} , {H}_{FL}^{y}$*,* and ${H}_{FL}^{z}$ denote effective magnetic fields arising from field-like torques generated by spin currents having x-axis, y-axis, and z-axis polarizations, respectively.

According to one embodiment, a configuration related to an operating temperature of a platinum-zirconium alloy-based magnetization switching device is such that a spin-orbit torque layer is formed as a platinum-zirconium alloy layer, and temperature-dependent switching characteristics are exhibited depending on a zirconium content (x) of the alloy layer.

The spin-orbit torque layer exhibits optimal spin-current polarization characteristics within a zirconium content range of 3 at% or more and 18.8 at% or less, and within the composition range, a z-axis-polarized component of the spin current is stably maintained even when a spin scattering rate increases due to temperature variation.

The magnetization switching device is configured such that switching operation is reproducible both in a low-temperature environment of -55 °C or less and in a high-temperature environment of 150 °C or more.

Zirconium atoms in the platinum-zirconium alloy layer control electron scattering paths within a crystal lattice so that a spin diffusion length does not sensitively decrease with temperature variation, thereby suppressing spin-current loss and stably maintaining magnetization switching of a free layer.

The spin-orbit torque layer is configured to maintain a spin-orbit torque efficiency at or above a predetermined level even in a high-temperature environment, which is attributed to stabilization of grain boundaries and suppression of spin scattering within the alloy layer. Accordingly, the platinum-zirconium alloy-based magnetization switching device is configured such that a polarization direction of a spin current is stably maintained under various temperature conditions and variation in a magnetization switching critical current density is minimized.

Further, according to one embodiment, a method for manufacturing a platinum-zirconium-based field-free magnetization switching device includes: forming a platinum-zirconium alloy layer on a substrate, forming a free layer made of cobalt or cobalt-iron-boron (CoFeB) on the platinum-zirconium alloy layer, stacking an asymmetric auxiliary layer on the free layer to asymmetrize a Rashba potential, thereby generating a z-axis-polarized spin current under a field-free condition, and inducing magnetization switching without an external auxiliary magnetic field by means of the z-axis-polarized spin current.

The platinum-zirconium alloy layer is formed using a sputtering process or a magnetron deposition process, and a zirconium content is controlled to be 3 at% or more and 18.8 at% or less.

The alloy layer is formed to simultaneously secure high spin-orbit interaction and low electrical resistivity.

The free layer is formed to have a thickness of 1.0 nm to 3.0 nm, and a magnetization direction thereof is oriented perpendicular to a polarization direction of a spin current generated in the spin-orbit torque layer.

The asymmetric auxiliary layer is made of at least one material selected from tantalum (Ta), ruthenium (Ru), and magnesium oxide (MgO), and asymmetrization of the Rashba potential by an asymmetric structure of the auxiliary layer generates a z-axis-polarized spin current without an external magnetic field.

The generated z-axis-polarized spin current reverses magnetization of the free layer, and magnetization switching is realized by a damping-like torque component induced by spin-orbit torque.

Accordingly, the platinum-zirconium-based field-free magnetization switching device implements magnetization switching solely by a spin-orbit torque effect without applying an external magnetic field, and is configured to be advantageous in terms of simplified manufacturing processes and large-area device integration.

Although the embodiments have been described above with reference to limited drawings, various modifications and variations may be made by those skilled in the art based on the above description.

For example, the described techniques may be performed in an order different from the described order, and/or components of the described systems, structures, devices, and circuits may be combined or arranged in forms different from those described, or may be replaced or substituted with other components or equivalents, while still achieving appropriate results.

Therefore, other implementations, other embodiments, and equivalents thereof also fall within the scope of the appended claims.

## Claims

1. A magnetic switching device, comprising:
a spin torque layer made of an alloy of platinum (Pt) and zirconium (Zr), the spin torque layer maintaining perpendicular magnetic anisotropy; and
a free layer formed on the spin torque layer, the free layer having a magnetization direction that is switchable,
wherein the magnetic switching device is based on a platinum-zirconium alloy.

2. The magnetic switching device of 1,
wherein the spin torque layer is formed of an alloy in which platinum (Pt) and zirconium (Zr) are present in a composition ranging from 0.1 at% to 18.8 at%.

3. The magnetic switching device of 2,
wherein the spin torque layer is formed of an alloy in which zirconium (Zr) is present in a composition ranging from 5.4 at% to 18.8 at%.

4. The magnetic switching device of one of claims 1 to 3,
wherein the spin torque layer is formed using a magnetron co-sputtering method.

5. The magnetic switching device of one of claims 1 to 4,
wherein the spin torque layer is made of an alloy having a resistivity ranging from 40 µΩ·cm to 150 µΩ·cm.

6. The magnetic switching device of one of claims 1 to 5,
wherein the free layer is formed of cobalt (Co) or cobalt-iron-boron (CoFeB).

7. The magnetic switching device of 6,
wherein the free layer has a thickness ranging from 0.8 nm to 1.2 nm.

8. The magnetic switching device of one of claims 1 to 7,
wherein the free layer is formed with a crystallographic orientation controlled to maintain perpendicular magnetic anisotropy.

9. The magnetic switching device of one of claims 1 to 8,
wherein an interface having a surface roughness of 0.2 nm or less is formed between the spin torque layer and the free layer.

10. The magnetic switching device of one of claims 1 to 9, further comprising:
a seed layer formed on a substrate and configured to control a growth direction and crystallinity of the spin torque layer; and
a capping layer formed on the free layer and configured to protect the free layer.

11. A method of manufacturing a platinum-zirconium alloy-based magnetic switching device, comprising:
forming a spin torque layer that maintains perpendicular magnetic anisotropy by depositing an alloy on a substrate using a target containing platinum (Pt) and zirconium (Zr); and
forming a free layer having a switchable magnetization direction on the formed spin torque layer.

12. The method of 11,
wherein the alloy is formed of platinum (Pt) and zirconium (Zr) having a composition ranging from 5.4 at% to 18.8 at%, and is formed using a magnetron co-sputtering method.

13. The method of 11 or 12,
wherein the free layer is formed of cobalt (Co) or cobalt-iron-boron (CoFeB) and is formed to have a thickness ranging from 0.8 nm to 1.2 nm.

14. The method of one of claims 11 to 13,
wherein a spin-orbit torque layer exhibits temperature-dependent switching characteristics according to a zirconium content (x) of a platinum-zirconium alloy layer,
wherein magnetization switching is reproducible in both a low-temperature environment of -55 °Cor higher and a high-temperature environment of 150 °C or lower, and
wherein, when the zirconium content is in a range from 3 at% to 18.8 at%, magnetization switching by spin-orbit torque is stably achievable with respect to temperature variation.

15. The method of one of claims 11 to 14, further comprising:
forming a platinum-zirconium alloy layer on a substrate;
forming a cobalt or cobalt-iron-boron (CoFeB) free layer on or under the platinum-zirconium alloy layer;
stacking, below the platinum-zirconium alloy layer, an in-plane magnetic anisotropy free layer to generate a z-axis-polarized spin current; and
inducing magnetization switching without an external magnetic field by the z-axis-polarized spin current,
wherein the method is for manufacturing a platinum-zirconium-based field-free magnetization switching device.
